(19) Europäisches Patentamt

European Patent Office

Office européen des brevets

(11) **EP 0 838 036 B1**

(12) **EUROPEAN PATENT SPECIFICATION**

(45) Date of publication and mention
of the grant of the patent:
**11.10.2006 Bulletin 2006/41**

(51) Int Cl.:
***G01R 33/44*** (2006.01)

(21) Application number: **96924072.0**

(22) Date of filing: **11.07.1996**

(86) International application number:
**PCT/GB1996/001676**

(87) International publication number:
**WO 1997/003366 (30.01.1997 Gazette 1997/06)**

(54) **APPARATUS FOR AND METHOD OF NUCLEAR QUADRUPOLE TESTING OF A SAMPLE**

GERÄT UND VERFAHREN ZUM TESTEN EINER PROBE DURCH KERNQUADRIPOLRESONANZ

APPAREIL ET PROCEDE PERMETTANT DE TESTER UN ECHANTILLON PAR RESONANCE
QUADRIPOLAIRE NUCLEAIRE

(84) Designated Contracting States:
**BE CH DE FI FR GB IT LI NL SE**

(30) Priority: **11.07.1995 GB 9514142**

(43) Date of publication of application:
**29.04.1998 Bulletin 1998/18**

(73) Proprietor: **BTG INTERNATIONAL LIMITED**
**London EC4M 7SB (GB)**

(72) Inventors:
  • **SMITH, John, Alec, Sydney**
    **London SW19 7QR (GB)**
  • **BEEVOR, Simon, Peter**
    **Kent BR8 8NL (GB)**
  • **ROWE, Michael, David**
    **London W4 2HU (GB)**

(74) Representative: **Cozens, Paul Dennis et al**
**Mathys & Squire**
**120 Holborn**
**London EC1N 2SQ (GB)**

(56) References cited:
**EP-A- 0 426 851**

• **JOURNAL OF MAGNETIC RESONANCE, vol. 92,
1991, pages 348-362, XP000220344 M.L. BUESS
ET AL.: "NQR Detection Using a Meanderline
Surface Coil" cited in the application**
• **MEASUREMENT SCIENCE AND TECHNOLOGY,
vol. 2, 1991, pages 866-871, XP000241996 E.
ROMMEL ET AL.: "Spectroscopic rotating-frame
NQR imaging (pNQRI) using surface coils"**
• **APPLIED PHYSICS LETTERS, vol. 28, 1976,
pages 49-51, XP002015008 T. JACH: "Detection
of nuclear quadrupole resonance via induced
longitudinal magnetization"**
• **JOURNAL OF MOLECULAR STRUCTURE, vol. 58,
1980, pages 63-77, XP002014975 T.
HIRSCHFELD, S.M. KLAINER: "Short Range
Remote NQR Measurments" cited in the
application**

**Description**

The present invention relates to apparatus for and a method of Nuclear Quadrupole Resonance testing a sample containing a given species of quadrupolar nucleus, and to apparatus for and a method of determining a measure of the distance of a sample from a probe, the sample containing a given species of quadrupolar nucleus.

The invention preferably relates to the testing of what are hereinafter termed "remote" samples. Although the following definition is not exclusive, remote samples are typically samples which lie outside the plane of the excitation/detection probe, often at a distance away from the probe which may be comparable with or greater than the largest cross-sectional dimension of the probe. With remote testing, it is often only possible to access the sample from one side, for instance if the sample is buried or concealed. Testing of remote samples which can only be accessed from one side is often termed "one-sided" testing; in such tests only the field from one side of the probe is utilised, the probe usually being shielded on the other side.

More particularly, the invention relates to the detection of the presence of remote samples containing quadrupolar nuclei.

As an example, the present invention has particular application to the detection of $^{14}$N quadrupole signals in drugs, such as cocaine and heroin, concealed on or within the person, possibly using a hand-held probe. Again, in industrial processes, it can be used to detect signals from quadrupole-containing materials. Such materials might be proteins in foodstuffs, or quadrupole containing substances on conveyor belts, inside furnaces or nuclear reactors or in chemically or physically hazardous surroundings in which the probe must be located away from the remainder of the testing apparatus, possibly even on one side only of the system. The probe may be located inside the pressure vessel of the nuclear reactor, which may be at extremes of temperature and pressure.

As another example, the invention has particular application to the detection of $^{14}$N quadrupole resonance signals from explosives such as TNT, RDX, HMX, PETN and compositions of such materials, for instance Semtex, contained within objects placed on the ground surface or buried underground, or to the detection of such explosives concealed beneath or behind concealing barriers, or on the person.

In the case of explosives, if provided in relatively small quantities (perhaps 10g to 100g or 1kg) they may for example be (a) scattered on the ground surface or (b) hand laid beneath the surface at a depth of a few centimetres (say 2 to 6cm). If provided in larger quantities (perhaps 1kg to 10kg or 20kg - case (c)), they are usually laid at a depth of about 1 to 20 or 25 cm. The probe would usually be at a distance of around 5 to 20cm from the ground, and the explosive would usually be between 1 and 5cm thick. If, say the distance from the probe to the ground were a typical 10cm and the thickness of the explosive were about 3cm, then the depth that the probe would need to examine would be roughly 8.5cm for case (a), 13cm for case (b) and 10 to 35cm for case (c).

Other possible uses of the invention are in exploration, for example, in mining, down boreholes (for instance for petrochemical exploration), or in structural engineering, for example, in the detection of faults in concrete or cement structures.

Amongst the most noteworthy of the quadrupolar nuclei are $^{11}$B, $^{14}$N, $^{23}$Na, $^{25}$Mg, $^{27}$Al, $^{39}$K, $^{51}$V, $^{55}$Mn, $^{59}$Co, $^{63}$Cu, $^{75}$As, $^{121}$Sb and $^{209}$Bi. The sample would usually be in polycrystalline or powdered rather than single crystal form.

As opposed to Nuclear Magnetic Resonance (NMR) techniques, Nuclear Quadrupole Resonance (NQR) techniques have the advantage that they do not require the sample to be placed in a strong static magnetic field; usually they function in the absence of any applied magnetic field. Interference from metallic or ferromagnetic objects can be eliminated.

In another related application, the invention may be used to provide an estimate of the quantity of sensitive material inside the sample under examination and its distance from the probe, providing additional applications in medicine as an adjunct to magnetic resonance imaging.

A method of detecting the presence of a given species of quadrupolar nucleus in a sample is known from WO 9509368 (British Technology Group Ltd.) which claims priority from United Kingdom Patent Application No. 9319875.2. The sample is subjected to r.f. excitation pulses of a given shape and the NQR response is observed as a free induction decay (f.i.d.) immediately following such a pulse (or pulses) and/or as echoes produced by application of two or more such pulses. The pulses are preferably shaped so as to be substantially rectangular in the frequency domain, and are subject to a phase variation which has a non-linear, preferably quadratic, variation with time over the duration of the pulse.

The aforementioned patent application, together with WO 9217794 (also to British Technology Group Ltd.), describes how the excitation pulses may be manipulated so as to reduce the deleterious effects of temperature or pressure variations experienced by the sample on the performance and sensitivity of the NQR tests.

WO 9221989 (also to British Technology Group Ltd.) describes how a quadrupole resonance image may be obtained from samples contained within opposed coil arrays. As stated above, the present invention is mainly concerned with cases in which access to the sample is from one side only, such as is a characteristic of buried explosives.

WO 9221987 and a closely related paper ("NQR Detection Using a Meanderline Surface Coil", by Buess, M. L. et al., J. Mag. Res., <u>92</u>, 1991, 348-362) describe a meanderline surface coil which is deliberately designed to detect explosives and narcotics only to a very limited depth, typically 1 or 2cm, a very small fraction of the overall dimension of the probe coil. The limited depth to which the meanderline coil is effective is completely inadequate for many purposes of practical interest.

A paper by Hirschfeld et al. entitled '' Short Range Remote NQR Measurements" (J. Mol. Struct., 58, 1980, 63-77) discloses the detection of buried explosives using NQR techniques. Separate experiments are described, one in which explosive is detected at a depth of 6cm, and one in which the depth is 10cm. In each case the testing apparatus is optimised for the particular depth of interest. There is no suggestion of any technique for the detection of explosive at any other depth or even of the desirability of detection at other depths.

A paper by Rommel et al entitled "Spectroscopic rotating-frame NQR imaging (NQRI) using surface coils" (Meas. Sci & Tech., 2, 1991, 866-871) discloses an NQR imaging procedure. Gradients of the radio-frequency amplitude, which are needed for the technique, are produced by surface coils. In a range of distance from the coils, the gradient of the radio-frequency amplitude is described as being practically constant. Radio-frequency excitation is applied by the surface coils to excite nuclear quadrupole resonance for a selected range of distance of a sample from the coils, the selected range of distance being greater than 1/10th of the maximum dimension of the coils. The technique requires the application of a large number of pulses with incrementally increasing pulse widths.

It has now been realised pursuant to the present invention that in the testing of remote samples it is desirable to carry out tests over a substantial selected range of distance away from the excitation/detection probe or probes, rather than at just one or two fixed distances. As used herein in this context, the term "substantial" is defined in terms of the range being, say, at least one tenth of the maximum cross-sectional dimension of the excitation/detection probe. Of course, other proportions would also be possible, such as 1/5 of the maximum dimension, or 1/3 or 1/2. The selected range may even be the same size or larger than the maximum dimension. In putting the present invention into practice, the present inventors used as the probe a plane spiral coil of outside diameter (maximum cross-sectional dimension) roughly 25cm. The selected range was between roughly 5 and 25cm from the coil.

It has furthermore been discovered that conventional excitation techniques such as that taught by Hirschfeld et al. would not operate satisfactorily over the substantial ranges referred to above. As explained in detail later, it has been discovered that, surprisingly, over any substantial range conventional techniques would be expected to give rise to a lack of uniformity of sensitivity of detection to the extent that samples at certain depths might not be detected at all.

The present invention in various preferred aspects seeks not only to provide good sensitivity over a substantial distance range but also with the selected range starting at a substantial distance (remoteness) from the probe or probes. In this context "substantial" connotes, say, at least 1/10, 1/5, 1/3 or 1/2 of, or even preferably greater than, the maximum dimension of the probe. This is to take into account that in many situations of practical interest the probe or probes may be a substantial distance away from the sample.

According to the present invention, there is provided apparatus for detecting the presence of a remote sample containing a given species of quadrupolar nucleus, comprising:- at least one probe having a given maximum cross-sectional dimension; means for applying excitation to the probe to excite nuclear quadrupole resonance for a selected range of distance of the sample from the probe, the apparatus being adapted to produce a non-uniform field over the selected range, the selected range being at least one tenth of the given maximum dimension of the probe, and the excitation comprising at least one excitation pulse; and control means for controlling the excitation, wherein:-

the probe is arranged so that for each excitation pulse of the excitation resonance response signals excited at distances within the selected range are received at the probe; and the apparatus further comprises means for detecting and processing resonance response signals excited at distances within the selected range received at the probe; characterised in that:-

the apparatus is for detecting the presence of a buried or concealed sample if the buried or concealed sample is present within the selected range of distance from the probe; the control means is adapted to control the excitation such that each excitation pulse of the excitation is of a selected width and root mean square power, the selected width and root mean square power being selected to be such as to ensure that each excitation pulse of the excitation excites respective non-zero resonance response signals at all distances within the selected range, supposing that the sample were present at all those distances; the detecting means is adapted to process the resonance response signals, excited at distances within the selected range by application of the excitation pulse or pulses of the selected width and root mean square power, independently of any resonance response signals excited at distances within the selected range by application of any other excitation pulses, thereby to detect the presence of the sample within the selected range of distance.

The restriction that the apparatus is adapted to produce a non-uniform field over the selected range is preferably intended to be interpreted to exclude configurations where the sample is accessed from both sides (for example, coils in Helmholtz pairs) using coils which are paired to produce highly uniform $B_1$ fields. Hence "non-uniform" may imply a variation of greater than, say, 3, 5 or 10% in field over the selected range.

By arranging the excitation applying means to generate non-zero resonance response signals at all distances within the selected range, the present invention can provide significantly more uniform sensitivity in the testing of remote objects over the selected range than would have been possible if conventional techniques had been employed in the testing of remote samples.

As an indication of the acceptable variation in sensitivity over the selected range, preferably the excitation is such that, for a given sample, over the selected range of sample distance the minimum resonance response signal detected would be no less than one twentieth, preferably no less than 1/10, 1/5, 1/4, 1/3 or 1/2, of the maximum resonance response signal.

Preferably the excitation is such as to generate a flip angle which is substantially constant over the selected range, so that the response signals would be as uniform as possible over the selected range. As taught herein, this can be achieved in a number of ways, including by the use of excitation in the form of appropriately shaped pulses.

The term "substantially constant" is to be interpreted in the light of the general level of inaccuracy inherent in NQR testing. For instance, the lowest flip angle may suitably be greater than 50%, 75% or 90% of the highest flip angle.

Preferably also, the excitation is such as to generate a flip angle of at least $90°_{effective}$ at at least one location, preferably at at least two separate locations, in the selected range. As explained in detail later in relation to the three preferred aspects of the present invention, this feature can afford an effective way of putting the invention into practice.

The probe or at least one of the probes may be in the form of a spiral coil, since this can transmit and receive excitation at a substantial distance from the probe or probes and over a substantial range of distance.

Preferably, the excitation is such as to generate a flip angle of greater than $90°_{effective}$ but less than $184°_{effective}$ at that extreme of the selected sample distance range nearer the or said one such probe. By this feature, as explained in detail later, a particular region of the flip angle versus distance curve can be utilised where flip angle actually increases with distance away from the or said one such probe. This can give rise to an NQR testing technique for which the sensitivity is considerably more uniform over the selected range than would have been possible if conventional techniques had been employed.

Preferably, the excitation is such that that extreme of the selected sample distance range nearer the or said one such probe is nearer the location for which flip angle is $180°_{effective}$ than that for which flip angle is $90°_{effective}$. This can ensure that the beneficial region of the flip angle versus distance curve is well utilised. It will be understood that a flip angle of $90°_{effective}$ is one which produces a maximum free induction decay at the receiver coil/probe; a flip angle of $180°_{effective}$ is one which produces a zero free induction decay at the receiver coil/probe. For an I = 1 spin system, these values correspond to $119°_{(actual)}$ and $257°_{(actual)}$ respectively.

For the same reason, preferably the excitation is such that that extreme of the selected sample distance range farther from the or said one such probe is farther than the location for which, between a flip angle of 0 and $180°_{effective}$, the excitation would generate the most intense resonance response signal in the sample.

Again, for the same reason, preferably the excitation is such that that flip angle at that extreme of the selected sample distance range farther from the or said one such probe is less than $90°_{effective}$, preferably less than 75, 60 or even $30°_{effective}$.

Preferably the excitation applying means is such as to apply, preferably at the same excitation frequency, at least a first and second kind of excitation, the first kind of excitation being arranged to generate a flip angle which differs at each and every location within the selected range from that generated by the second kind of excitation at that particular location.

This is a particularly advantageous way of achieving a sensitivity of testing which is considerably more uniform over the selected range than would have been possible if conventional techniques had been employed, in that the two (or more) kinds of excitation can be individually optimised for two or more sub-ranges within the selected range.

Preferably, the plurality of kinds of excitation are interleaved with one another to form a repeating cycle of excitation, each of the kinds of excitation being applied during each such repeating cycle. In this manner the overall duration of the test need not be increased substantially by comparison with the case where only one kind of excitation were applied.

If the plurality of kinds of excitation are interleaved, preferably in each such repeating cycle the excitation generating the lower or lowest flip angle precedes the excitation generating the higher or highest flip angle. This has been found to be a feature which is particularly important for ensuring a sufficient uniformity of sensitivity.

Again for uniformity of sensitivity, preferably the detection means is adapted to acquire and process the resonance signals generated in response to the respective kinds of excitation separately.

The apparatus of the present invention may be for determining a measure of the distance of the sample from the or said one such probe, in which case it preferably includes means for comparing the resonance signals generated in response to the respective kinds of excitation and determining from the comparison a measure of the distance of the sample from the or said one such probe.

By this feature is provided a relatively simple but effective technique for determining the distance of a given remote sample. Such information could be particularly useful if the sample is in some way concealed.

Preferably, the comparing and determining means is adapted additionally to determine from the comparison a measure of the quantity of the given species of quadrupolar nucleus. Preferably again, the excitation applying means is adapted to apply at least two different pairs of first and second kinds of excitation, since use of at least two different pairs of excitation can improve the sensitivity of the tests, especially where more than one sample is present in the selected range.

The present invention extends to a method of detecting the presence of a remote sample containing a given species of quadrupolar nucleus, comprising; providing at least one probe having a given maximum cross-sectional dimension; applying excitation to the probe to excite nuclear quadrupole resonance for a selected range of distance of the sample from the probe, a non-uniform field being produced over the selected range, the selected range being at least one tenth of the given maximum dimension of the probe, and the excitation comprising at least one excitation pulse; for each excitation pulse of the excitation, receiving at the probe resonance response signals excited at distances within the selected range; and detecting and processing resonance response signals excited at distances within the selected range received at the probe; characterised in that:-

the method is for detecting the presence of a buried or concealed sample if the buried or concealed sample is present within the selected range of distance from the probe; the method further comprises controlling the excitation such that each excitation pulse of the excitation is of a selected width and root mean square power, the selected width and root mean square power being selected to be such as to ensure that each excitation pulse of the excitation excites respective non-zero resonance response signals at all distances within the selected range, supposing that the sample were present at all those distances; processing the resonance response signals, excited at distances within the selected range by application of the excitation pulses of the selected width and root mean square power, independently of any resonance response signals excited at distances within the selected range by application of any other excitation pulses, thereby to detect the presence of the sample within the selected range of distance.

The probe or the probes generally may be positioned (at any one time) on one side of the sample only.

Preferably, the excitation is such that, for a given sample, over the selected range of sample distance the minimum resonance response signal detected would be no less than one twentieth, preferably no less than 1/10, 1/5, 1/4, 1/3 or 1/2, of the maximum resonance response signal.

Preferably, the excitation is such as to generate a flip angle which is substantially constant over the selected range.

Preferably, the excitation is pulsed excitation repeated at a pulse repetition time $\tau$, the sample has a spin-lattice relaxation time $T_1$, and the value of $\tau/T_1$ is less than 5, preferably less than 2, 1, 0.5, 0.1 or even 0.05. By this feature, it has been found that the sensitivity of detection can be more nearly uniform over the selected range.

Preferably, the excitation is such as to generate a flip angle of at least $90°_{effective}$ at at least one location, preferably at at least two separate locations, in the selected range.

Preferably, the excitation is such as to generate a flip angle of greater than $90°_{effective}$ but less than $180°_{effective}$ at that extreme of the selected sample distance range nearer the or said one such probe.

Preferably, the excitation is such that that extreme of the selected sample distance range nearer the or said one such probe is nearer the location for which flip angle is $180°_{effective}$ than that for which flip angle is $90°_{effective}$.

Preferably, the excitation is such that that extreme of the selected sample distance range farther from the or said one such probe is farther than the location for which, between a flip angle of 0 and $180°_{effective}$, the excitation would generate the most intense resonance response signal in the sample.

Preferably, the excitation is such that that flip angle at that extreme of the selected sample distance range farther from the or said one such probe is less than $90°_{effective}$, preferably less than 75, 60 or even $30°_{effective}$.

Preferably, at least a first and second kind of excitation are applied, preferably at the same excitation frequency, the first kind of excitation being arranged to generate a flip angle which differs at each and every location within the selected range from that generated by the second kind of excitation at that particular location.

Preferably the plurality of kinds of excitation are interleaved with one another to form a repeating cycle of excitation, each of the kinds of excitation being applied during each such repeating cycle.

Preferably, in each such repeating cycle the excitation generating the lower or lowest flip angle precedes the excitation generating the higher or highest flip angle.

Preferably, the resonance signals generated in response to the respective kinds of excitation are acquired and processed separately.

The method may be a method of determining a measure of the distance of the sample from the or said one such probe, in which case preferably the resonance signals generated in response to the respective kinds of excitation are compared and a measure of the distance of the sample from the or said one such probe is determined from the comparison.

Preferably, additionally determined from the comparison is a measure of the quantity of the given species of quadrupolar nucleus.

Preferably, at least two different pairs of first and second kinds of excitation are applied.

As a general example of the efficacy of the present invention, the example of detecting the presence of explosives (in this particular case, the explosive RDX) in a given area is considered. An acceptable signal-to-noise ratio (defined as signal r.m.s noise voltage) is commonly considered to be 5:1. Experiments conducted pursuant to the present invention show that a signal-to-noise ratio of 5:1 can be attained from a moderately sized sample of RDX at a realistic distance from a probe (some tens of centimetres) in a few seconds. Similar acquisition times would apply alike to smaller samples at lesser depths and larger samples at greater depths. Indeed, within limits, simultaneous detection of explosives over a range of depths could be achieved within a similar acquisition time. It has been estimated that the technique of the present invention could be employed to clear an area of explosives in an acceptably short time.

Preferred features of the present invention as well as examples of its operation and the theory underlying the invention will now be described, purely by way of example, with reference to the accompanying drawings, in which:

Figure 1 shows a series of plots of the signal received by a probe as sample distance, Z, is varied;

Figure 2 is a block diagram of a preferred embodiment of testing apparatus according to the present invention;

Figure 3 is a block diagram of a pulse shaping unit forming part of the testing apparatus;

Figure 4 shows a series of plots of signal intensity versus flip angle for the various $\tau/T_1$ values shown in the inset, $\tau$ being the pulse repetition time, $T_1$ being the spin-lattice relaxation time;

Figure 5 shows a series of plots of signal intensity versus distance, Z, for the various values of the ratio $\tau/T_1$ shown in the inset;

Figures 6(a) and 6(b) are spectra for samples of the explosive RDX at two different distances from an r.f. probe of the testing apparatus;

Figure 7 is a spectrum similar to those of Figures 6 but for a different distance, Z;

Figure 8 is a pulse sequence for use with an embodiment of the present invention;

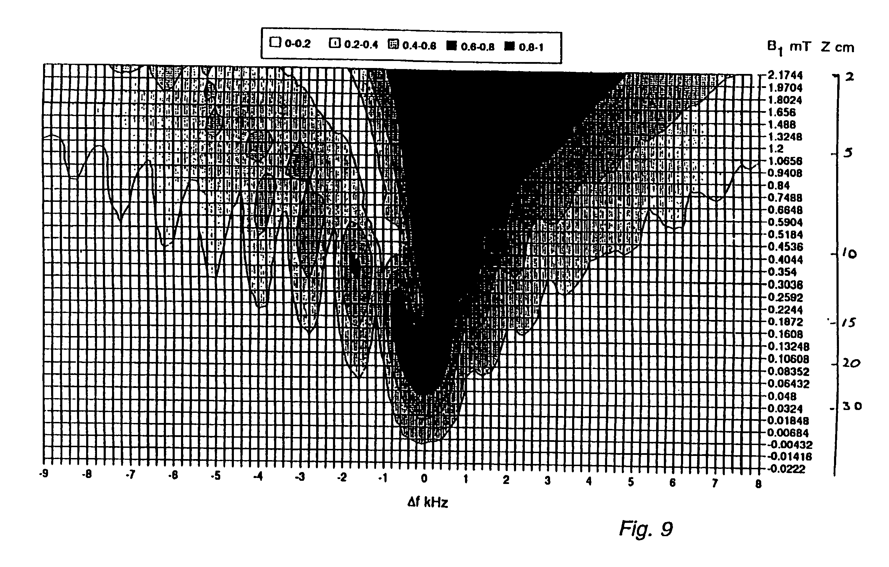

Figure 9 is a contour plot of signal intensity versus $B_1$ field and frequency offset for an adiabatic half passage pulse sequence;

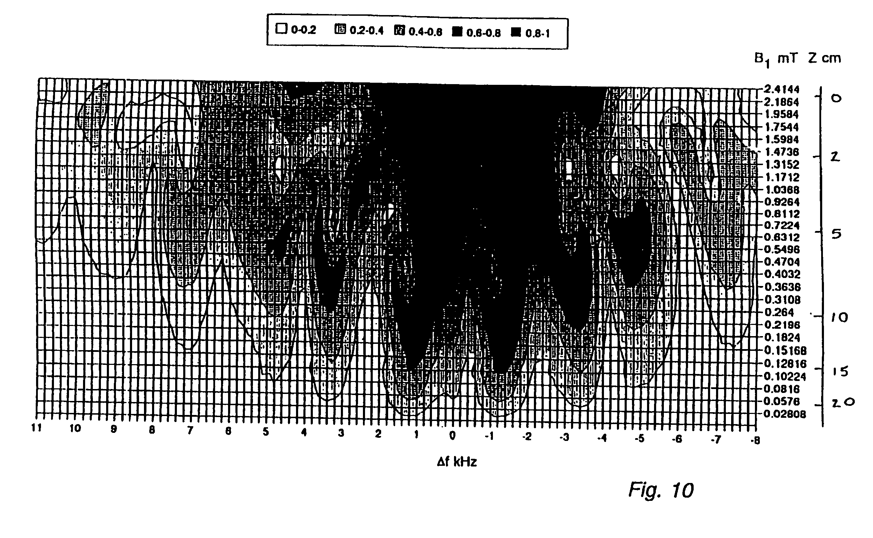

Figure 10 is a similar plot for a BIR-4 pulse sequence;

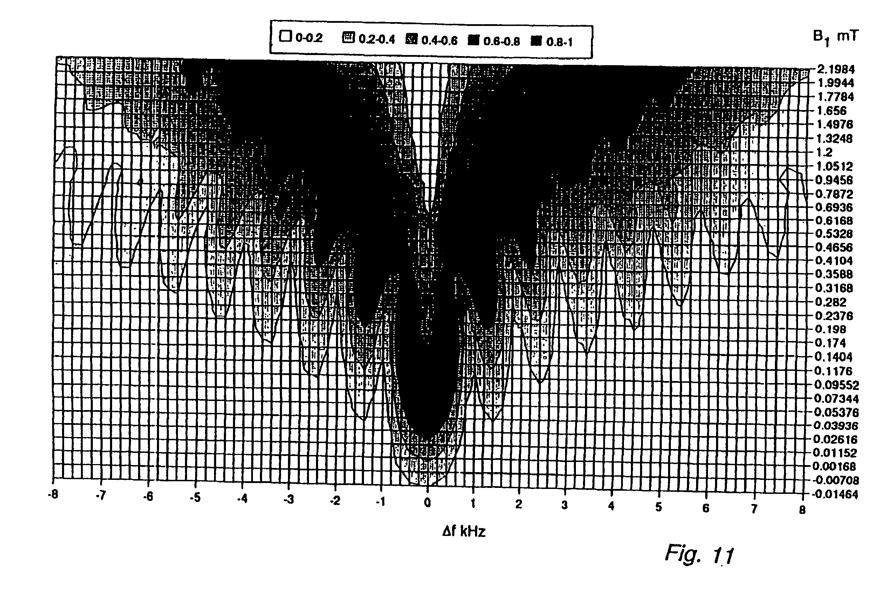

Figure 11 is a similar plot for a simple rectangular pulse sequence; and

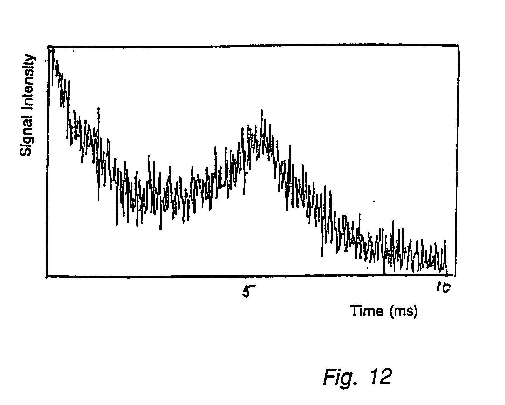

Figure 12 is a plot of signal intensity versus time for a BIR-4 pulse sequence.

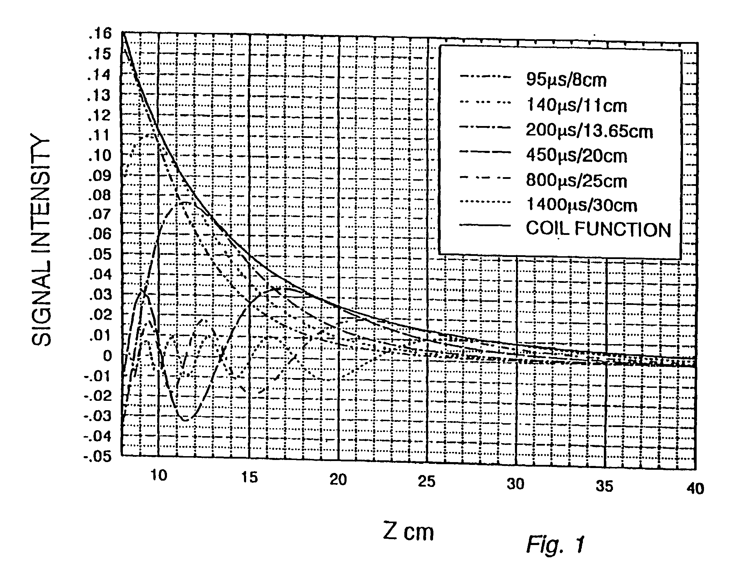

The theory underlying the invention is first described, with reference to Figure 1.

Known techniques, as described in WO-92/21989 A, for detecting the presence of a particular substance in a sample conventionally do so whilst the sample is on a conveyor belt or the like, and do so using a pair of Helmholtz r.f. coils, the sample being placed between, and close to, the coils. In this fashion, it is possible to maintain a relatively uniform r.f. field throughout the sample, and hence maintain relatively uniform sensitivity of detection.

In the detection of remote samples such as buried or concealed objects, on the other hand, the distance from the sample to the probe would usually be significant, greater for instance than some measure of the size of the probe such as its maximum dimension (usually the outer diameter of the r.f. coil). Also, it is generally possible to place a probe or probes on one side of the sample only. In such circumstances, with the use of conventional excitation, the r.f. coil is not generally capable of generating a uniform r.f. field $B_1$ within the total field of view; this can yield a sensitivity of detection which may be highly non-uniform. This is explained in detail in the following analysis.

An excitation pulse at the resonance frequency $\omega_Q$ of the relevant quadrupolar nuclei may be regarded as generating a nominal flip angle $\alpha$ which depends on the r.f. field $B_1$ and the pulse width $t_w$. Unless the context otherwise demands, the term "flip angle" as used herein connotes the actual rather than "effective" value. For example, for spin-1 systems, 119° is the flip angle which gives the maximum signal, thus corresponding to an effective 90° flip.

For spin-1 nuclei

$$\alpha = 2\ \gamma\ B_1\ t_w \qquad (1)$$

The signal $S_x$ generated in the coil by a polycrystalline sample depends on $\alpha$ according to the expression

$$S_x \propto \omega_Q \cdot \frac{\sin\alpha - \alpha\cos\alpha}{\alpha^2} \qquad (2)$$

which has a maximum at $\alpha=119°$ (0.66$\pi$ radians), a zero at 257° (1.43$\pi$ rad.) and the first negative maximum at 340° (1.90$\pi$). Equation 2 has been derived for the fully relaxed case where $\tau$ is greater than or equal to $5T_1$. $\tau$ is the pulse repetition time, the time between successive repeated pulses or pulse sequences. $T_1$ is the spin-lattice relaxation time for the relevant nuclear species.

Reference is now made to Figure 1. Figure 1 shows a series of plots of the signal received by a true spiral r.f. coil as sample distance from the plane of the coil, Z, is varied; each individual plot is for a pulse whose width (duration) (termed "$t_p(119°)$") has been chosen to produce the optimum flip angle of 119° at a particular sample distance, Z. The $t_p(119°)$ pulse width is given alongside the sample distance in the inset to the figure. The signal intensity scale has been normalised to 1 at Z = 0. Each plot therefore represents the signal received by the coil as the sample is moved from its 119° position.

In Figure 1 the full line, termed ("coil function") represents, for a true spiral coil, the signal received by the coil from the response of a sample at Z to a $t_p(119°)$ pulse appropriate to the particular value of Z. Since a $t_p(119°)$ pulse has been chosen, the magnetisation induced in the sample will be the same for each Z value. By the reciprocity law for transmission and reception of magnetic fields for a coil, this plot, with suitable scaling, would be identical to a plot of the distribution of $B_1$ field over distance Z. The variation of $B_1$ with Z for a true spiral coil is governed by Equation 4, given below.

Aside from the coil function plot, the remaining plots are theoretical plots, being plots of the relevant Bessel function response curve. However, the particular pulse widths $t_p(119°)$ at given values of Z have been derived experimentally for the particular apparatus employed to test experimentally the theories underlying the present invention. In more detail, the plots of Figure 1 other than the "coil function" plot have been derived by a simultaneous solution of Equations 1, 2 and 4. Given the variation for a particular pulse of the $B_1$ field with Z from Equation 4, $B_1$ can then be converted into flip angle using Equation 1 to yield the dependency of flip angle with Z; it will be apparent that for a particular pulse the flip angle generated in the sample reduces as Z is increased. The signal intensity generated at the sample for given Z can then be deduced given the variation of flip angle with Z from Equation 2. Finally, the signal received at the (receiver) coil can be obtained from the variation of the signal intensity at the sample with Z by a further application of Equation 4.

Whilst the plots of Figure 1 are specific to the particular type of spiral coil employed, analogous plots could of course be derived for other coil configurations by use of a different relationship in Equation 4.

It is be noted that the curves presented in Figure 1 have been derived for the situation where $\tau/T_1$ is greater than or equal to 5. In other words, it is assumed that the response signal is fully relaxed such that there is no saturation of the signal.

Suppose now that it is desired to detect buried samples up to maximum distances of, say, 25 to 30 cm from the plane of the coil. Suppose further that, to produce the maximum signal from a sample at a depth of (say) 30cm, the $B_1$ field and/or pulse width $t_w$ is adjusted so as to give the optimum flip angle (for example 119°), at this distance. This would be achieved by setting the pulse width at 1400$\mu$s for a root mean square pulse power of 675W using the particular testing apparatus developed pursuant to the present invention. Figure 1 then shows the signal received by the r.f. probe as the sample distance Z is varied, using the pulse duration (1400$\mu$s) which is optimised for the 25 to 30cm depth (see the short-dashed line). There is indeed a maximum in the signal intensity between 25 and 30cm, but at intermediate distances the signal oscillates in magnitude and sign, and, at some distances, for example 13.5 and 17.5cm, the signal is actually zero, so that samples centred near these distances would generate very weak or even zero responses. There are in fact no less than seven null points in the region from Z = 10cm to the region of interest such as could give rise to a serious lack of sensitivity.

Moreover, if there were two samples to be detected within the field of view, with one adjacent a positive peak and one adjacent a negative peak, their signals could have nearly or exactly opposite phase at resonance. Hence the signals could nearly or even exactly cancel, thus generating a false negative response from the testing apparatus. In the example described above, if one sample were at a distance of 26cm and the other at a distance 14cm, it can be seen from Figure 1 that signal cancellation could occur. A similar effect could also occur with a single elongate sample.

Furthermore, it the temperatures of the two samples and therefore their resonance frequencies were different, for example due to thermal gradients in the ground or within the sample, partial or complete cancellation could occur at any distance. The problem could not be overcome by improving the received signal intensity at shorter distances, for instance by using a shorter pulse of, say, 140 $\mu$s duration at the same power. Figure 1 shows that this would produce acceptable signals at distances of between 8 to 14cm, but at (say) 30cm the received signal would be unacceptably weak.

It will be understood that the strength of a signal relative to noise can be improved according to the number of signal accumulations. Hence by "unacceptably weak" is meant that an adequate signal-to-noise ratio cannot be achieved within a given acquisition time. Such a time is usually defined by physical restraints such as the speed of a conveyor belt transporting the sample past the testing apparatus, or the need to clear a given area of explosives in as short a time as possible (for instance 1 or 2 minutes per square metre).

The present invention seeks to provide, solutions to the above described problems concerned with a non-uniform $B_1$ field and hence non-uniform sensitivity of detection. Firstly, a preferred embodiment of testing apparatus for putting the invention into effect is described.

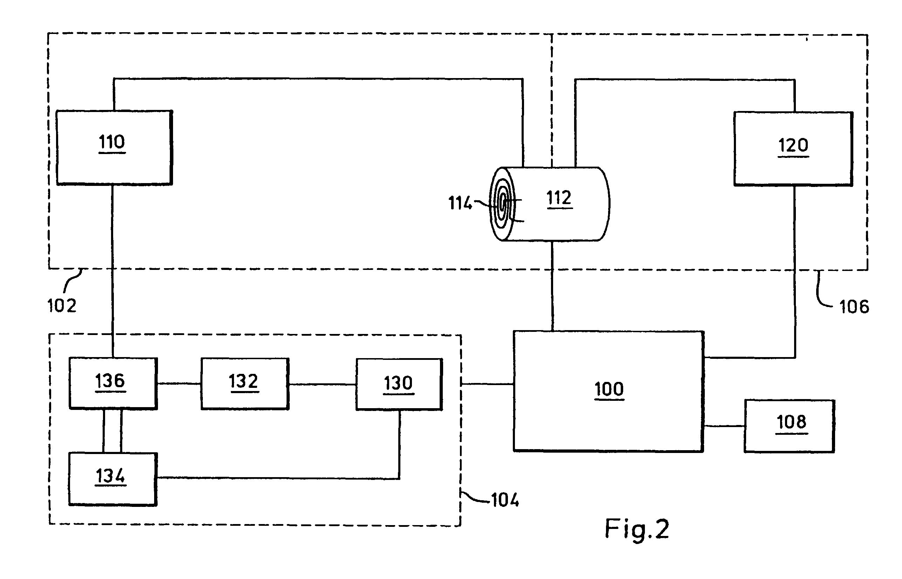

The preferred embodiment is described with reference to Figure 2. The embodiment is particularly suited to the detection of objects or samples underground or beneath or behind concealing barriers, where it is important to be able to move the r.f. probe during the measurement of NQR responses. The apparatus is suitable for the application of simple excitation pulses (that is, those which are rectangular in the time domain). It is however particularly suited to the application of shaped adiabatic pulses or pulses which have a substantially rectangular shape in the frequency domain. This is by virtue of its capacity to modulate simultaneously the amplitude and phase/frequency of the pulse.

The apparatus comprises in general terms a control computer 100, means 102 for applying one or more radio-frequency excitation pulses to the sample covering a selected excitation frequency range and for a given duration, means 104 for generating composite or shaped pulses, that is frequency/phase and/or amplitude modulated pulses for passing to the excitation applying means 102, means 106 for detecting the NQR response signal, and means 108 for generating an alarm signal in dependence upon whether the presence of a given substance is detected above a predetermined threshold. This may trigger an audio or visual alarm which alerts the operator to the presence of the sample to the detected.

In more detail, the excitation pulse application means 102 includes a radio-frequency power amplifier 110 whose output is connected to an r.f. excitation and detection probe 112. The probe contains one or more spiral antenna coils 114 whose dimensions depend on the field of view required. In many applications, the probe, together with its attendant preamplifiers and isolating circuitry, may need to be portable. The remainder of the apparatus would not normally be portable, but would be connected to the probe by a length of cable. The probe may have one open unshielded end to apply to the sample under examination, and one closed end, perhaps shielded within a suitable screening enclosure. Sufficient clearance should be left between the coil and the box.

In certain circumstances, a Faraday shield or cage on the open side of the probe may be employed to reduce E-field effects; typically this would be a thin sheet of metal (Al, Cu), with a slit down the centre to reduce eddy current effects. The width of the slit would be optimised according to geometry and frequency of operation. E-field effects occur with piezoelectric samples such as sand.

The probe also forms part of the detection means 106, which includes an r.f. preamplifier, receiver and detection circuitry 120. The frequency/phase and amplitude modulated pulses are generated by the shaped pulses generating means 104 under the control of the control computer 100.

The means 104 for generating shaped pulses, (that is, frequency/phase, and/or amplitude modulated pulses) includes a pulse programmer 130, and a spectrometer 132, manufactured by SMIS, United Kingdom, for generating the r.f. carrier signal at a known carrier reference frequency and fixed amplitude, the signals being gated by the trigger signals from the pulse programmer 130, and a signal function generator 134, manufactured by Famell, U.K (model SFG 25). The r.f. carrier passes to a pulse shaping unit 136. The function generator 134 is operated by a TTL logic signal from the pulse programmer 130.

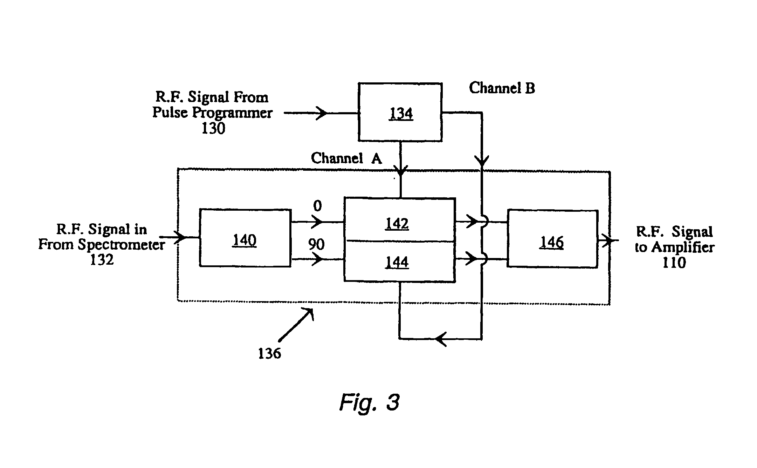

The pulse shaping unit 136 is now described in more detail with reference to Figure 3. A 0-90 degrees 5MHz two-way combiner 140, manufactured by Mini Circuits (U.K.) under model no. PSCQ-2-5, itself fed with the r.f. signal from the spectrometer 132, supplies two mixer circuits 142 and 144. Each such mixer circuit is also fed with a modulation signal via a respective Channel A and B from the function generator 134.

The actual mixer circuits employed were constituted as Hatfield(U.K.) double-balanced mixer units (model 1754). However, other suitable circuits are also available such as a Burr-Brown model MPY 634 precision analog multiplier based radio-frequency mixer. The main criterion is that the modulation of the r.f. input by the function generator is linear over the largest possible range of voltage; an additional low power amplifier may be required to achieve this. If a precision analog multiplier is employed, it may be necessary to incorporate capacitors between the power supplies and earth and to incorporate trimming capacitors to remove low frequency voltage offsets from the mixing circuit which might otherwise cause pulse distortion. Two other potential sources of non-linearity must also be eliminated, namely distortion of the pulse due to the limited band width of the r.f. probe and distortion due to non-linearity in the r.f. power amplifier.

The output from the mixer circuits 142 and 144 is passed via a combiner 146 to the amplifier 110. The combiner is a Hatfield (U.K.) component model no. DR102 or 3320.

The present invention is preferably capable of detecting samples at considerable range from the plane of the coil or coils 114 and over a significant range of distance. A typical detection range is from 8 to 35cm. To achieve this detection range, in the preferred embodiment a planar Archimedean spiral coil is used, with an outside diameter and number of turns determined by the depth which it is intended to probe. Although in the preferred embodiment a planar spiral coil is employed, any form of surface coil would be appropriate. Because of the requirement of remote detection, coils of the solenoid, saddle or Helmholtz form are not generally appropriate.

For samples which are likely to be found at distances not greater than, say, 30 to 50cm from the coil plane, it has been discovered pursuant to the present invention that an Archimedean spiral of the form

$$r = a \frac{\theta}{2\pi} \qquad (\theta \ in \ radians) \quad (3)$$

with a (the distance between conductor centres) = 1.5cm has a satisfactory performance when used with a tubular conductor of diameter 0.8cm.

A total of 7.75 turns can produce a spiral of outside diameter about 25cm and overall length 3.4m. Supposing that the wavelength, $\lambda$, of the r.f. carrier frequency is 5.2MHz, the overall length is $\lambda/17$. This is close to the rule-of-thumb limit of $\lambda/20$ usually believed necessary to avoid phase effects.

A planar Archimedean spiral generates an on-axis r.f. field $B_1$, ($\perp$) given by the expression

$$B_1(\perp) = \frac{I}{b}\left[ \ln(\sqrt{\theta^2 + 1} + \sqrt{\theta^2 + \frac{Z^2}{b^2}}) - \frac{\sqrt{\theta^2 + 1}}{\sqrt{\theta^2 + \frac{Z^2}{b^2}}} \right]_{\theta_1}^{\theta_2} \quad (4)$$

where for the present embodiment $\theta$ varies between 1.5 $\pi$ ($\theta_1$) to 17 $\pi$ ($\theta_2$) radians, b=a/2$\pi$, a=1.5cm and I is the r.f. current. The effective field of view at a given distance Z, meaning the dimensions of the circle in a plane parallel to that of the plane of the spiral for which the total $B_1$ field has fallen off by 25% relative to its value at the centre, depends on the distance apart, Z, of the two planes; it is 14cm for Z = 3.2cm and 20cm for Z = 28.2cm, which it has been found pursuant to the present invention give acceptable performance for detection of explosives in the range of, say, 8 to 35cm from the plane of the r.f. probe.

The function of Equation 4 is shown plotted in Figure 1 as the "coil function" curve.

The present invention has the aim, amongst other aims, of solving the problems encountered in the prior art and discussed previously. These problems are associated with the detection of samples which are located in a non-uniform r.f. field within the total field of view. Preferred embodiments are now described in order of increasing r.f. pulse power.

For all of the following described embodiments, examples have been provided of the operation of the invention with reference to one particular resonance frequency (5.2 MHz) of the explosive RDX. The invention would, of course, also function satisfactorily at other resonance frequencies and for other NQR substances.

In a first embodiment, based on minimal r.f. power requirements, usually a pulse sequence involving a single r.f. pulse is employed, repeated in a time of the order of or less than $T_1$, the spin-lattice relaxation time of the nuclear species being excited. Strict control is exercised over the pulse width and power.

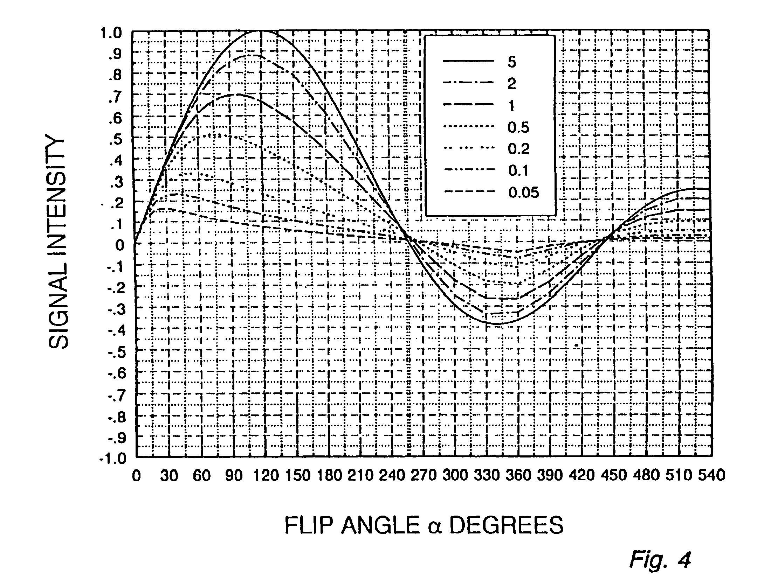

By way of background, it should be explained that, if the pulse repetition time, $\tau$, is of the order of $T_1$ (typically less than $5T_1$), then the response will not be completely relaxed, (A sequence of repeated pulses for which $\tau$ is of the order of $T_1$ is herein termed a "$T_1$ limited cycle.") In this case, Equation 2 no longer holds true. In fact, it has been shown by Vega (J. Chem. Phys, 61 1093 (I974)) that peak signal decreases in intensity and moves to lower flip angle as $\tau/T_1$ decreases from a value of 5. The various equations presented by Vega have been solved numerically pursuant to the present invention for the case of quadrupole resonance of an I = 1 powdered sample. The results are shown in Figure 4. This figure shows a series of plots of signal intensity versus flip angle for the $\tau/T_1$ values shown in the inset; signal intensity is normalised to a maximum signal intensity of unity obtained at a flip angle $\alpha$ of 119° for the $\tau/T_1$=5 case (assumed to be fully relaxed). It can be seen that peak signal decreases in intensity and moves to lower flip angle as $\tau/T_1$ decreases from a value of 5. For all the plots, zero signal intensity is reached at $\alpha$=257°. It should be noted that Figure 4 shows the signal intensity at the sample rather than at the (receiver) coil.

It will be apparent from the true spiral "coil function" plot of Figure 1 that, all other factors being equal, a signal received at a receiver coil from a more distant sample will be less than that received from a nearer sample. On the other hand, it will be apparent from Figure 4 when taken in combination with Equations 1 and 4 that over a range of flip angle (extending up to 257°), and hence over a range of distance, the signal generated at the sample for a given pulse can actually increase the more distant the sample is. The first embodiment seeks to balance these two effects to produce a received signal intensity which is as invariant with distance as possible over a specified range of distance (which range is itself as large as possible). It has been found pursuant to the present invention that these effects can better be balanced the lower the value of the ratio $\tau/T_1$, in other words that for lower values of the ratio $\tau/T_1$ the observed signal shows a reduced variation with sample distance.

In more detail, in the first embodiment the (usually) single pulse in the pulse sequence is of such a width and root mean square power as to produce a zero in the signal response (corresponding to $\alpha=257°$) at a distance slightly less than the minimum value at which the sample or samples are to be detected. This ensures that the desired range corresponds to the appropriate range of flip angle as determined from Figure 4 and that there are no null points or negative going signals proceeding outwardly from the minimum distance.

Further, the value of the ratio $\tau/T_1$ is set relatively low (less than 5, preferably less than 2, 1 or even 0.5), so that the maximum signal response at the sample is achieved at a sufficiently low value of flip angle. At values of flip angle lower than the value corresponding to this maximum, signal intensity decreases rapidly. Hence the useable flip angle range (and thus the desirable range of distance from the plane of the coil) is bounded approximately on the one side by the flip angle corresponding to the maximum signal and on the other side by the zero crossing flip angle value of 257°. As can be seen from Figure 4 the useable flip angle range is greater at lower values of $\tau/T_1$.

Now suppose, for example, that the pulse width $t_w$ is set to generate a 257° pulse at an on-axis distance of 2.05cm from the plane of the probe and a 119° pulse at 5.2cm, and that $\tau/T_1$ is set at 0.5. At distances greater than 2.05cm, the flip angle diminishes and the free induction decay signal intensity generated in a probe notionally located at the sample would increase. On the other hand, at the actual, distant r.f. probe, all other factors being equal the received signal would decrease according to Equation 2. The net effect, it has been discovered, is a partial or complete cancellation of the two conflicting effects over a limited range, such that over a distance of, say, 2.5 to 13cm the received signal varies very little.

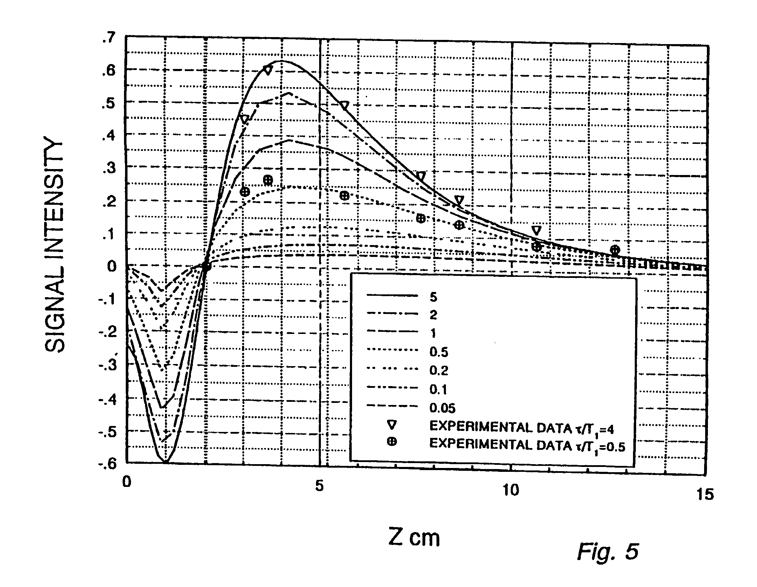

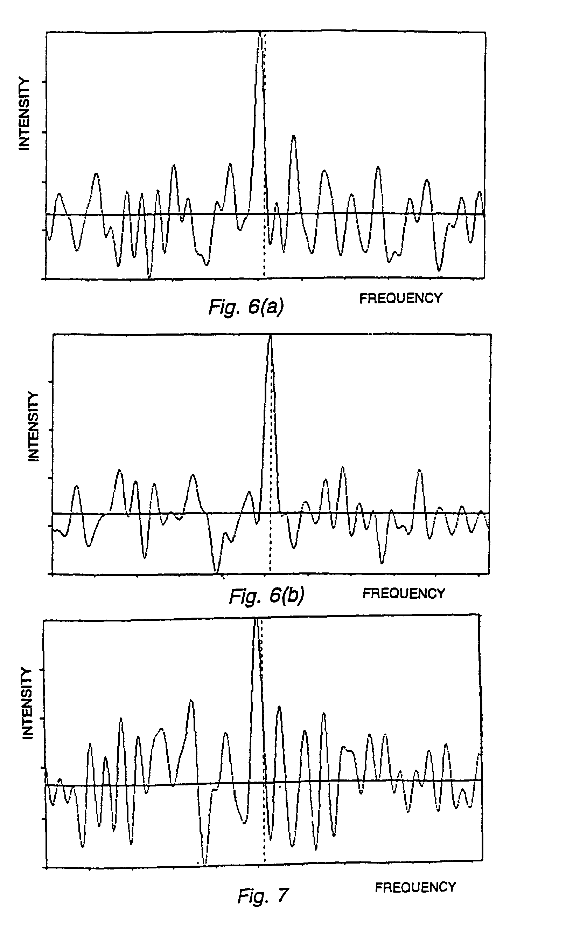

Reference is now made to Figure 5 to illustrate this point. Figure 5 shows the variation of signal intensity (as received by the probe) with distance Z from the plane of the probe along the coil axis for various values of the ratio $\tau/T_1$. As stated above the r.f. pulse is selected to give a 257° flip angle at Z = 2.05cm and a 119° flip angle at Z = 5.2cm. In Figure 5, the various curves are theoretical predictions, whilst the data points are experimentally derived values, as shown in the inset to the figure.

The theoretical plots were derived from the plots of Figure 4 in a fashion analogous to that described for the derivation of the plots of Figure 1, except that Equation 2 was replaced by the Vega equations as discussed above (or their graphical solution as shown in Figure 4).

The experimental results were derived using a 38g sample of "PE-4" (based on the explosive RDX) at two different values of the ratio $\tau/T_1$, namely 4 and 0.5, corresponding to the triangular and circular symbols respectively. In Figure 5, the theoretical plots were scaled to the peak of the fully relaxed experimental data ($\tau/T_1 = 4$).

It can be seen that the experimental results agree well with the theoretical predictions.

It is noticeable in Figure 5 that for $\tau/T_1=5$ the maximum signal intensity does not occur at the $\alpha=119°$ position of Z, but at a somewhat nearer Z value. This is on account of the attenuation at greater distances of the signal from the sample as received by the probe, in accordance with Equation 4.

It can be deduced from the experimental data in Figure 5 that, between Z = 3 and Z = 13cm, the $\tau/T_1 = 4$ response varies by a factor of 10, whilst the $\tau/T_1 = 0.5$ response varies by a factor of only 2.4. More generally, it can be seen from the various theoretical curves that, for lower values of $\tau/T_1$, for example, 0.5 or less, the observed signal obtained by Fourier transformation of the f.i.d. does show a considerably reduced variation with distance above 3cm than pertains for higher values of the ratio. Hence it is preferable to employ these lower values of the ratio $\tau/T_1$.

However, for certain substances, for example, the explosive RDX, a practical lower limit on the value of the ratio $\tau/T_1$ can be imposed by the free induction decay time, $T_2^*$. For the free induction decay to be detected properly, it is usually thought that the pulse repetition time $\tau$ should not be much less than $5T_2^*$. For RDX at room temperature $T_2^*$ is roughly 1.5ms whilst $T_1$ is roughly 15ms. Hence the lowest satisfactory value of $\tau$ for RDX at room temperature may be 7.5ms, corresponding to a value of $\tau/T_1$ of 0.5.

In the example described above, typically a positive signal of substantial signal strength could be obtained over a range of 2.5 to 13cm. As another example, for a pulse set to produce a flip angle of 119° at 14cm and an appropriate value for the ratio $\tau/T_1$, a positive detectible signal could be derived over a range of roughly 10 to 20cm with the received signal intensity varying by a factor of about five.

It is estimated that r.m.s. pulse powers of less than 100 W would be required to achieve a signal-to-noise ratio of 5:1 for a sample of RDX of about 40 gm between 9 and 16cm from the plane of the probe in a time of less than 10 s. For the same power, longer times would be required to detect a 1kg sample at a distance of 30cm. Whilst the reduction in signal intensity as $\tau/T_1$ is reduced can be partly offset by the use of more pulse cycles within a given acquisition time, a $T_1$-limited cycle as described in the first preferred aspect of the present invention may be relatively slow in operation. However, it does require only low r.f. powers. It would be particularly appropriate in circumstances where it was required to detect the presence of remote objects over a relatively small range of distance.

In a second embodiment, two or more pulses (or pulse sequences) are used at the same excitation carrier frequency but are of differing powers and/or have differing pulse widths. The powers and/or widths are selected to generate the optimum flip angle of 119° at two or more different distances from the plane of the r.f. probe, a particular power/width corresponding to a particular distance. The f.i.d. responses from each of the pulses are acquired and processed independently, and adjusted to produce the same phase after Fourier transformation. The resulting absorption spectra are then added, or preferably the area under each resulting absorption spectrum is added,

A particularly fast sequence uses just two differing pulse types and is termed herein a two pulse sequence. This principle of the technique is described with reference first to Figure 1 in relation to an exemplary two pulse sequence, although of course the description could equally be applied to sequences with a greater number of differing pulse types.

The pulse sequences could be $T_1$-limited cycles as described in relation to the first embodiment discussed above. However, it may be desirable not to employ fast pulsing sequences; the pulse separation, $\tau$, may in this embodiment preferably be greater than 3 or even 5 times $T_1$, so that a fully relaxed state is reached before each new pulse.

In the exemplary sequence, pulse 1 in the two pulse sequence is selected for the apparatus developed pursuant to the present invention to have a width $t_w$ of between 100 and 140 $\mu$s and an r.m.s. power of about 675W; it can be deduced from Figure 1 that such a pulse, given sufficient quantities of the substance to be detected, could generate satisfactory signal responses at distances of between, say, 8 and 15cm from the plane of the r.f. probe (which in the preferred embodiment is the spiral coil to which reference has already been made). Pulse 2 has a width of between 200 and 450 $\mu$s at the same r.m.s. power, or alternatively the same width as pulse 1 but with the r.f. power adjusted to increase the $B_1$ field proportionally. It can be deduced from Figure 1 that pulse 2 would generate satisfactory responses at distances of between 15 and 30 or 35cm from the plane of the r.f. probe. Hence the two differing pulses in combination (if suitably arranged) can generate satisfactory responses at distances of between, say, 8 and 35cm from the plane of the r.f. probe, without there being any null points or negative going signals in this range. The exemplary two-pulse sequence is therefore particularly suited to the detection of buried or concealed explosives.

Experimental spectra obtained using the above-described exemplary two-pulse sequence to detect differing quantities of the explosive RDX at different distances from the plane of the r.f. probe are shown in Figures 6 and 7. In Figures 6(a) and (b) are shown the f.i.d.'s of the $^{14}$N response from the 5.19MHz line of RDX with a 100$\mu$s pulse of r.m.s. power 675W. For Figure 6(a) the RDX was in a quantity of a few grammes at a distance of 9cm from the plane of the r.f. probe, whilst for Figure 6(b) the corresponding values were a four tens of grammes at a distance of 13.65cm. An acceptable signal-to-noise ratio was achieved for both cases. Equally, Figure 7 shows that an acceptable signal-to-noise ratio was achieved with RDX in a substantially larger quantity at a distance of 30cm, with a 200$\mu$s pulse of the same r.m.s. power and frequency. 200$\mu$s is the value of $t_p(119°)$ for 13.65cm.

In fact it has been found pursuant to the present invention that with the two-pulse sequence described above (specifically one in which one pulse has a width of 100$\mu$s and the other a width of 450$\mu$s), good results can be obtained over a range of Z from 8 to 35cm.

It will of course be understood that other pulse combinations than the exemplary two-pulse sequence described above are possible according to the nature of the particular problem to be solved. The pulse widths can be adjusted to match the requirements of the particular search, that is, the quantities of material to be detected and the distances at which they are likely to be found. It may be necessary to use more than two differing pulses if the samples to be detected are located over a wide range of distance.

One possible combination of pulses employs a pulse which is shaped so as to have a substantially rectangular shape in the frequency domain at least as the longer or longest of the pulses. Such a pulse would have a better bandwidth performance than a simple rectangular pulse, which would be of value at greater distances. For simplicity one or more simple rectangular pulses could be employed for the other pulses.

The use of two or more pulse sequences of differing widths does not necessarily increase the acquisition time proportionally. This is achieved by interleaving of the two or more pulse sequences. If the pulse sequences are so interleaved, it is important that they are applied in the correct order, if more than one sample is likely to lie in the field of view.

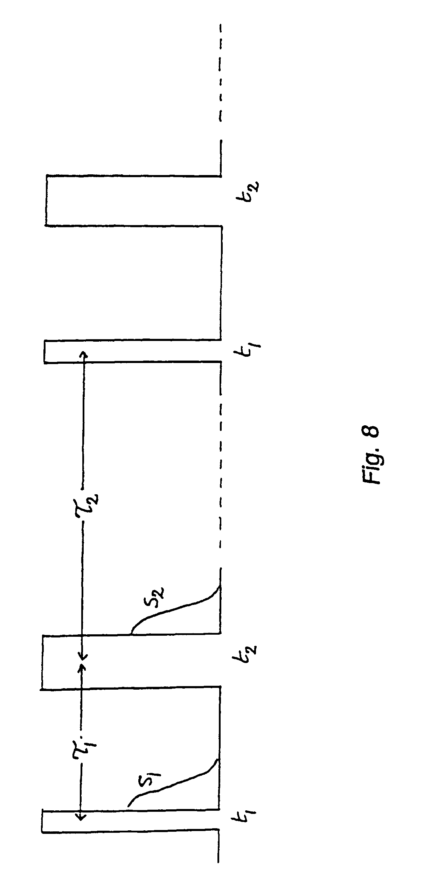

In a two pulse sequence, for example, because $T_2^*$, the f.i.d. time, is invariably much shorter than $T_1$, the spin-lattice relaxation time, the shorter pulse should precede the longer. This point is illustrated first with reference to Figure 8, which shows a preferred interleaved pulse sequence for the purposes of this aspect of the invention.

The first pulse is a short pulse of width $t_1$, following which the first f.i.d. $S_1$ is captured and digitised. There is then a time interval of about $\tau_1 = 2T_2^*$, during which the nuclei excited by this pulse, which are located predominantly closer to the probe, dephase. $\tau_1$ may suitably be as low as roughly $T_2^*$ to as high as roughly 3 or $5T_2^*$. The dephasing may be partial or complete (so that in the latter case no transverse magnetisation exists), dependent upon the distance of the sample from the plane of the r.f. probe and hence the flip angle (which may be the maximum 119° or some lesser value). Also, since $T_2^* \ll T_1$, the longitudinal magnetisation will not have recovered to any significant extent.

The second, longer pulse, of width $t_2$ (or the r.f. power may be varied, and the width kept constant) is now applied and its f.i.d. $S_2$ captured and digitised. The signal from this pulse would come predominantly from a sample or samples further away from the plane of the r.f. probe.

The two-pulse sequence is repeated after an interval after the second pulse $\tau_2$ which is of the order of $T_1$ to $2T_1$ (say, between 0.5 and $3T_1$) at the temperature of the sample or samples. The pulse repetition rate, $\tau$, is thus $\tau_1 + \tau_2$. After N such repetitions, the summed signals $S_1$ and $S_2$ are separately acquired, processed and examined by the computer, the separately Fourier transformed data finally being added if appropriate. Separate processing is important to avoid the cancellation of one positive signal by a negative signal.

If two or more samples are present at different depths, as mentioned above it is important that the former shorter pulse is applied before the latter longer pulse. In this way there need be no risk that the (say) two samples interfere with each other so that only a negligible response signal is produced. This is now explained further with reference to a 140/450 $\mu$s combination of pulses (see Figure 1).

The case is first considered in which the nearer sample is in the region where the latter, longer 450 $\mu$s pulse would produce a negative signal at the probe (between Z=10 and 13cm), whilst the farther sample is at a significantly greater depth. The former, shorter 140$\mu$s pulse would generate nearly a 119° flip angle at the nearer sample, so that no significant longitudinal magnetisation would remain to be excited by the latter pulse. Hence the nearer sample would generate no response to the latter pulse, and there would thus be no interference between the nearer and farther sample, the farther sample being detected by the latter pulse.

The case is next considered where the nearer sample is in the positive response region of the latter, longer pulse (Z>13cm, beyond the zero crossing point of the latter pulse), but is either within the excitation range of the shorter pulse (say, Z<20cm) or nearer than the maximum for the longer pulse (say, Z<18cm). The farther sample is again at a significantly greater depth. If the nearer sample were within the excitation range of the former, shorter pulse at all, the former pulse would generate less than a 119° flip, and some longitudinal magnetisation would therefore remain to be excited by the latter pulse. However, since signals received by the probe from the two samples would both be positive, the resultant effect would be additive. Again, there is therefore no interference, either partial or complete, between the responses generated by the two pulses if two or more samples are present.

Considering now finally the case where the nearer sample is either outside the excitation range of the shorter pulse (say, Z>20cm) or farther than the maximum for the longer pulse (say, Z>18cm), it is clear that the response from the latter, longer pulse would predominate in respect of both samples, so that there would again be satisfactory detection of both samples.

Suppose, on the other hand, contrary to the preferred manner of putting the invention into practice, that the two pulses were applied in the reverse order, with the longer coming first, and again that there were two or more samples within the field of view.

In the first place, as already described in relation to Figure 1, the response signal from the nearer sample could partially or completely cancel that from the farther. The signal $S_2$ (in respect of the longer but now former pulse) could therefore be weak or even undetectable, despite the presence of material to be detected in both the near and the far region.

Furthermore, by the time of arrival of the second, shorter pulse, after an interval of about $2T_2{}^*$, nuclei in the near region already perturbed by the first pulse could have dephased, so that $S_1$ (in respect of the shorter but now latter pulse) could also be weak or even undetectable, despite the presence of material to be detected in the near region. Hence where two (or more) samples are present at different depths, a situation might arise in which no signal can be detected at either depth with either pulse.

In short, then, applying the two pulses in reverse order leads to problems because of the possibility that the longer pulse may give rise, at intermediate depths, to signals which are negative and which hence may cancel signals from the shorter pulse.

It will be apparent from the foregoing discussion that it is important not only that the shorter and longer pulses are applied in the correct order, but also that they are adjusted to create the maximum 119° flip angle at the correct relative distances. Specifically, it is preferable that the 119° flip angle position of the shorter pulse falls within the first range of distance, approaching from infinity, for which the longer pulse generates an opposite signed signal intensity. If the 119° position of the shorter pulse were either further away from or nearer to the plane of the probe, this pulse would be incapable of making the necessary compensation for the negative going range of the longer pulse.

If more than two different pulse types (say, three or four) were used, each pulse being optimised for a different depth, then the sensitivity of detection might be more uniform over depth. On the other hand, the cancellation effects referred to previously might be more significant, and it may be particularly important to ensure that the shortest pulse is applied first in the sequence, and the longest last, but with pulses optimised for adjacent distances being separated from each other. If, say, at least four pulses were used, then it might be advantageous to apply the pulses in the order first, third, second, fourth (first denoting the shortest) provided that the first and third, and second and fourth, pulses were not prone to mutual cancellation.

As an example of the application of an interleaved two pulse sequence, the explosive RDX at 295K is considered, whose $^{14}$N signal at 5.19 MHz has $T_2{}^* = 1.4$ms and $T_1 = 12$ms. Without interleaving of the two pulses $t_1$ and $t_2$, each sequence would occupy 1.5s for 100 accumulations, setting the pulse repetition time to 15ms. Hence the total duration of both pulse sequences would be 3s (neglecting the pulse widths). On the other hand, with interleaving of the pulses, the total time with $\tau_1 = 3$ms and $\tau_2 = 15$ms is 1.8s.

This principle can, as an additional feature, be employed to provide an estimate of the distance of a sample from the plane of the r.f. probe and/or of the approximate quantity of the material of interest. This is a consequence of the fact that at constant pulse r.f. power, and hence constant r.f. current to the probe, both the $B_1$ field and the r.f. signal induced in the probe depend only on the distance of the sample from the plane of the probe. This conclusion is strictly true only for on-axis locations, but the modifications needed to allow for samples off-axis are not large and are well-known from publications such as that of C.B. Bosch and J.J.H. Ackerman, "NMR Basic Principles and Progress", Vol. 27, Springer-Verlag, 1992, pp. 3-44 (see in particular Figures 3a to 3d on pages 8 and 9).

With this additional feature, it is important that the signal is captured after each pulse and processed in an identical fashion. For instance, the same receiver, the same computer, the same phase gain, and so on, should be used, failing which the accuracy of the distance or quantity estimation could be prejudiced.

In putting this additional feature into practice, two different sequences are used, both sequences being fully relaxed (that is, with $\tau \geq 3$ or $5\,T_1$). One such sequence contains pulses of width $t_1$ and the other pulses of width $t_2$; each pulse has the same r.m.s. power. Each sequence on its own provides strong signals from different spatially localised regions. For example, as is apparent from Figure 1, a pulse of width $140\mu s$ produces strong signals from samples at distances of between 8 and 14cm, whilst the corresponding distance range for a pulse of width $450\mu s$ is between 14 and 35cm. Distance to the sample is determined by comparing the accumulated signal after (say) 100 pulses of width $t_1$, which is termed $S_1$, with that after the same number of pulses of width $t_2$, say $S_2$. The ratio $S_1/S_2$ is a sensitive function of distance over a considerable range. Referring to Figure 1, it can be seen that $S_1=S_2$ at a distance (z) of 15.6cm from the plane of the r.f. probe. At other distances, its value can be both positive or negative, taking into account the phases of the accumulated signals. The following table provides values of the ratio $S_1/S_2$ for various values of Z.

| Z(cm) | 9 | 12 | 15 | 18 | 21 |
|---|---|---|---|---|---|
| $S_1/S_2$ | 3.6 | -2.7 | 1.4 | 0.55 | 0.38 |

The particular pair of pulse types described above provides reasonable spatial localization over distances from 8 to about 20cm from the plane of the r.f. probe; other combinations will have different ranges of distance.

Once the depth of the sample is known, the stronger signal can be used to provide an estimate of quantity. This can, for example, be derived from the theoretical plots in Figure 1 and a prior calibration of the signal to be expected from the testing apparatus from a known quantity of the material to be detected at a known distance from the r.f. probe. It will be understood that the accuracy of the quantity estimate will be affected by the size and shape of the sample, the uncertainty being greater the larger the extension of the sample along the $B_1$ gradient.

If there is more than one sample in the field of view, a minimum of two different pairs of pulse sequences are needed to provide an estimate of their distances and quantities. A computer programme or the like, which is based on the graphical data in Figure 1, determines from two different values of the signal ratios $(S_1/S_2)_1$ and $(S_1/S_2)_2$ from each pair of sequences which combination of quantities and distances best fits the experimental ratios. However, where there are two (or more) samples there will be a correspondingly greater uncertainty and poorer resolution than in the case of a single sample.

If it is required to perform the spatial localization in the minimum time, the pair of pulse sequences may be interleaved, under the same conditions as have previously been discussed in relation to the second preferred aspect of the present invention. However, it is now necessary to allow for the effect of the different flip angles induced by pulse 1 on the signal generated by pulse 2. For example, if pulse 1 has a width of $140\mu s$, Figure 1 shows that at distances greater than (say) 13cm, there will still be a finite longitudinal magnetisation present in any sample located in this region, which will affect the response following pulse 2, as has already been discussed. If the spin-lattice relaxation time $T_1$ of the quadrupolar nuclei is known, this effect can be allowed for by means of the usual relaxation equations, and the ratio $S_1/S_2$ can still provide an estimate of distance, but with a greater uncertainty than when the two pulse sequences are conducted separately under fully-relaxed conditions.

In the preferred embodiments, any uncertainty in the temperature of the sample can be allowed for as taught, for example, in WO 9217794 (British Technology Group Limited). It is particularly preferred to use excitation pulses which are shaped to have a quadratic phase or frequency variation and a near-rectangular amplitude variation in the frequency domain. Such pulses can have comparatively low power consumption whilst having comparatively high bandwidth. They have been discussed in detail in WO 9509368 (British Technology Group Ltd.), whose disclosure is incorporated herein by reference, and which claims priority from United Kingdom Patent Application No. 9319875.2.

If the substance to be detected is buried underground, its temperature is likely to vary in a relatively predictable fashion according to its depth underground. The invention may in those circumstances employ one or more temperature sensors in conjunction with a look-up table to predict the resonant frequency of the substance.

In the case of the second embodiment, if temperature does vary with the distance of the sample from the probe in a predictable manner, compensation for any temperature differences may be made by optimising the first kind of excitation to a first resonance frequency and value of $T_1$ relevant to a first temperature (and hence sample distance), and by optimising the second kind of excitation to a second resonance frequency and value of $T_1$ relevant to a second such temperature, corresponding, say to a greater sample distance.

Furthermore, in the case of the detection of buried objects, any temperature uncertainties are likely to become less substantial as depth increases, since temperature conditions underground tend to be more stable at greater depth. As against this, due to the requirements of the testing apparatus, excitation bandwidth is likely to be more restricted at greater depths, and hence such temperature induced frequency shifts as may exist may become more difficult to cope with.

It will be understood that the present invention has been described above purely by way of example, and modifications of detail can be made within the scope of the invention.

## Claims

1. Apparatus for detecting the presence of a remote sample containing a given species of quadrupolar nucleus, comprising:-

   at least one probe (112) having a given maximum cross-sectional dimension;
   means (110) for applying excitation to the probe (112) to excite nuclear quadrupole resonance for a selected range of distance of the sample from the probe, the apparatus being adapted to produce a non-uniform field over the selected range, the selected range being at least one tenth of the given maximum dimension of the probe (112), and the excitation comprising at least one excitation pulse; and
   control means (106) for controlling the excitation, wherein:-

   the probe is arranged so that for each excitation pulse of the excitation resonance response signals excited at distances within the selected range are received at the probe; and
   the apparatus further comprises means for detecting and processing resonance response signals excited at distances within the selected range received at the probe;
   **characterised in that**:-

   the apparatus is for detecting the presence of a buried or concealed sample if the buried or concealed sample is present within the selected range of distance from the probe (112);
   the control means (106) is adapted to control the excitation such that each excitation pulse of the excitation is of a selected width and root mean square power, the selected width and root mean square power being selected to be such as to ensure that each excitation pulse of the excitation excites respective non-zero resonance response signals at all distances within the selected range, supposing that the sample were present at all those distances;
   the detecting means (106) is adapted to process the resonance response signals, excited at distances within the selected range by application of the excitation pulse or pulses of the selected width and root mean square power, independently of any resonance response signals excited at distances within the selected range by application of any other excitation pulses, thereby to detect the presence of the sample within the selected range of distance.

2. Apparatus according to Claim 1 wherein the excitation is such as to generate, for a given sample, over the selected range of sample distance a minimum resonance response signal no less than one twentieth, preferably no less than 1/10, 1/5, 1/4, 1/3 or ½, of the maximum resonance response signal.

3. Apparatus according to Claim 1 or 2 wherein the excitation is such as to generate a lowest flip angle which is greater than 50%, 75%, or 90% of the highest flip angle over the selected range.

4. Apparatus according to any of the preceding claims, wherein the excitation is pulsed excitation repeated at a pulse repetition time $\tau$, the sample has a spin-lattice relaxation time $T_1$, and the value of $\tau/T_1$ is less than 5, preferably less than 2, 1, 0.5, 0.1 or even 0.05.

5. Apparatus according to any of the preceding claims, wherein the excitation is such as to generate a flip angle having a value which is at least the value of flip angle which gives the maximum resonance response signal, at at least one location, preferably at at least two separate locations, in the selected range.

6. Apparatus according to any of the preceding claims wherein the probe (112) or at least one of the probes (112) is in the form of a spiral coil (114).

7. Apparatus according to any of the preceding claims wherein the excitation is such as to generate a flip angle of a value greater than the value of flip angle which gives the maximum resonance response signal, but of a value less than the lowest value of flip angle greater than 0° which gives a zero resonance response signal, at that extreme of the selected sample distance range nearer the or said one such probe (112).

8. Apparatus according to Claim 7, wherein the excitation is such that that extreme of the selected sample distance range nearer the or said one such probe (112) is nearer the location for which the flip angle is the lowest value of flip angle greater than 0° which gives a zero resonance response signal than the location for which the flip angle is such as to give a maximum resonance response signal,

9. Apparatus according to Claim 7 or 8, wherein the excitation is such that that extreme of the selected sample distance range further from the or said one such probe (112) is further than the location for which, for a flip angle having a value between 0° and the lowest value of flip angle greater than 0° which gives a zero resonance response signal, the excitation is such as to generate the most intense resonance response signal in the sample.

10. Apparatus according to any of Claims 7 to 9, wherein the excitation is such that the flip angle at that extreme of the selected sample distance further from the or said one such probe (112) is less than the value of flip angle which gives the maximum resonance response signal.

11. Apparatus according to any of the preceding claims, wherein the excitation comprises a first kind of excitation and the excitation applying means (110) is also adapted to apply a second kind of excitation, preferably at the same excitation frequency, the first kind of excitation being arranged to generate a flip angle which differs at each and every location within the selected range from that generated by the second kind of excitation at that particular location, and the detecting means (106) is adapted to detect the response signals from each of the first and second kinds of excitation.

12. Apparatus according to any of Claims 1 to 10, wherein the excitation comprises a first kind of excitation, and the excitation applying means (110) is also adapted to apply a second kind of excitation comprise a pulse or pulses having a differing width and/or root mean square power than that of the first kind of excitation, the second kind of excitation preferably being at the same excitation frequency as that of the first kind of excitation.

13. Apparatus according to Claim 12, wherein the detecting means is adapted to process the resonance response signals from the first kind of excitation independently of the resonance response signals from the second kind of excitation, and to adjust the resonance response signals from the first kind of excitation and/or the resonance response signals from the second kind of excitation, so as to produce the same phase after Fourier transformation.

14. Apparatus according to Claim 13, wherein the detecting means is adapted to add the absorption spectra arising from Fourier transformation of the resonance response signals from the first kind of excitation and Fourier transformation of the resonance response signals from the second kind of excitation, and preferably the detecting means is adapted to add the area under each absorption spectrum.

15. Apparatus according to any of Claims 11 to 14, for determining a measure of the distance of the sample from the or said one such probe (112), including means (100) for comparing the resonance signals generated in response to the respective kinds of excitation and determining from the comparison a measure of the distance of the sample from the or said one such probe (112).

16. Apparatus according to any of Claims 11 to 15, wherein the excitation applying means (110) is such as to apply the plurality of kinds of excitation interleaved with one another to form a repeating cycle of excitation, each of the kinds of excitation being applied during each such repeating cycle.

17. Apparatus according to Claim 16, wherein in each such repeating cycle the excitation generating the lower or lowest flip angle precedes the excitation generating the higher or highest flip angle.

18. Apparatus according to any of Claims 15 to 17 wherein the comparing and determining means (100) is adapted additionally to determine from the comparison a measure of the quantity of the given species of quadrupolar nucleus.

19. Apparatus according to any of Claims 11 to 18 wherein the excitation applying means (110) is adapted to apply at least two different pairs of first and second kinds of excitation.

**20.** Apparatus according to Claim 11, wherein the first kind of excitation is such as to generate non-zero resonance response signals at all distances within the selected range of distance, and the second kind of excitation is such as to generate non-zero resonance response signals at all distances within a further selected range of distance.

**21.** Apparatus according to Claim 21, wherein the selected range of distance and the further selected range of distance are contiguous or overlap.

**22.** Apparatus according to any preceding claim, further comprising means for generating an alarm signal in dependence upon whether the presence of a given substance is detected above a predetermined threshold.

**23.** A method of detecting the presence of a remote sample containing a given species of quadrupolar nucleus, comprising:

> providing at least one probe (112) having a given maximum cross-sectional dimension;
> applying excitation to the probe to excite nuclear quadrupole resonance for a selected range of distance of the sample from the probe (112), a non-uniform field being produced over the selected range, the selected range being at least one tenth of the given maximum dimension of the probe (112), and the excitation comprising at least one excitation pulse;
> for each excitation pulse of the excitation, receiving at the probe resonance response signals excited at distances within the selected range; and
> detecting and processing resonance response signals excited at distances within the selected range received at the probe (112);
> **characterised in that**:-

> > the method is for detecting the presence of a buried or concealed sample if the buried or concealed sample is present within the selected range of distance from the probe (112);
> > the method further comprises controlling the excitation such that each excitation pulse of the excitation is of a selected width and root mean square power, the selected width and root mean square power being selected to be such as to ensure that each excitation pulse of the excitation excites respective non-zero resonance response signals at all distances within the selected range, supposing that the sample were present at all those distances;
> > processing the resonance response signals, excited at distances within the selected range by application of the excitation pulses of the selected width and root mean square power, independently of any resonance response signals excited at distances within the selected range by application of any other excitation pulses, thereby to detect the presence of the sample within the selected range of distance.

**24.** A method according to Claim 23 wherein the excitation is such that, for a given sample, over the selected range of sample distance the minimum resonance response signal detected is no less than one twentieth, preferably no less than 1/10, 1/5, 1/4, 1/3 or ½, of the maximum resonance response signal.

**25.** A method according to Claim 23 or 24 wherein the excitation is such as to generate a lowest flip angle which is greater than 50%, 75%, or 90% of the highest flip angle over the selected range.

**26.** A method according to any of Claims 23 to 25 wherein the excitation is pulsed excitation repeated at a pulse repetition time $\tau$, the sample has a spin-lattice relaxation time $T_1$, and the value of $\tau/T_1$ is less than 5, preferably less than 2, 1, 0.5, 0.1 or even 0.05.

**27.** A method according to any of Claims 23 to 26 wherein the excitation is such as to generate a flip angle having a value which is at least the value of flip angle which gives the maximum resonance response signal, at at least one location, preferably at at least two separate locations, in the selected range.

**28.** A method according to any of Claims 23 to 27 wherein the excitation is such as to generate a flip angle of a value greater than the value of flip angle which gives the maximum resonance response signal, but of a value less than the lowest value of flip angle greater than 0° which gives a zero resonance response signal, at that extreme of the selected sample distance range nearer the or said one such probe (112).

**29.** A method according to Claim 28 wherein the excitation is such that that extreme of the selected sample distance range nearer the or said one such probe (112) is nearer the location for which the flip angle is the lowest value of flip angle greater than 0° which gives a zero resonance response signal than the location for which the flip angle is such as to give a maximum resonance response signal.

30. A method according to Claim 28 or 29 wherein the excitation is such that that extreme of the selected sample distance range farther from the or said one such probe (112) is further than the location for which, for a flip angle having a value between 0° and the lowest value of flip angle greater than 0° which gives a zero resonance response signal, the excitation is such as to generate the most intense resonance response signal in the sample.

31. A method according to any of Claims 28 to 30 wherein the excitation is such that that flip angle at that extreme of the selected sample distance range farther from the or said one such probe (112) is less than the value of flip angle which gives the maximum resonance response signal.

32. A method according to any of Claims 23 to 31 wherein the excitation comprises a first kind of excitation, and the method further comprises applying a second kind of excitation, preferably at the same excitation frequency, the first kind of excitation being arranged to generate a flip angle which differs at each and every location within the selected range from that generated by the second kind of excitation at that particular location.

33. A method according to any of Claims 23 to 32, wherein the excitation comprises a first kind of excitation, and the method further comprises applying a second kind of excitation comprising a pulse or pulses having a differing width and/or root mean square power than that of the first kind of excitation, the second kind of excitation preferably being at the same excitation frequency as that of the first kind of excitation.

34. A method according to Claim 33, further comprising processing the resonance response signals from the first kind of excitation independently of the resonance response signals from the second kind of excitation, and adjusting the resonance response signals from the first kind of excitation and/or the resonance response signals from the second kind of excitation, so as to produce the same phase after Fourier transformation.

35. A method according to Claim 34, further comprising adding the absorption spectra arising from Fourier transformation of the resonance response signals from the first kind of excitation and Fourier transformation of the resonance response signals from the second kind of excitation, and preferably the method comprises adding the area under each absorption spectrum.

36. A method according to any of Claims 32 to 35, wherein the plurality of kinds of excitation are interleaved with one another to form a repeating cycle of excitation, each of the kinds of excitation being applied during each such repeating cycle.

37. A method according to Claim 36, wherein in each such repeating cycle the excitation generating the lower or lowest flip angle precedes the excitation generating the higher or highest flip angle.

38. A method according to any of Claims 32 to 37, wherein the resonance signals generated in response to the respective kinds of excitation are acquired and processed separately.

39. A method according to any of Claims 32 to 38, of determining a measure of the distance of the sample from the or said one such probe (112), wherein the resonance signals generated in response to the respective kinds of excitation are compared and a measure of the distance of the sample from the or said one such probe (112) is determined from the comparison.

40. A method according to Claim 39, wherein additionally determined from the comparison is a measure of the quantity of the given species of quadrupolar nucleus.

41. A method according to any of Claims 32 to 40, wherein at least two different pairs of first and second kinds of excitation are applied.

42. A method according to Claim 41, wherein the first kind of excitation is such as to generate non-zero resonance response signals at all distances within the selected range, and the second kind of excitation is such as to generate non-zero resonance response signals at all distances within a further selected range of distance.

43. A method according to Claim 42, wherein the selected range of distance and the further selected range of distance are contiguous or overlap.

**Patentansprüche**

1. Gerät zum Ermitteln des Vorliegens einer fernen Probe mit einer vorgegebenen Art quadrupolaren Kerns, das aufweist:

   wenigstens eine Sonde (112) mit einer vorgegebenen maximalen Querschnittsgröße;
   eine Einrichtung (110) zum Anlegen von Anregung an die Sonde (112), um nukleare Quadrupolresonanz für einen ausgewählten Entfernungsbereich der Probe von der Sonde anzuregen, wobei das Gerät so ausgelegt ist, dass es über den ausgewählten Bereich ein nicht-uniformes Feld erzeugt, wobei der ausgewählte Bereich wenigstens ein Zehntel der vorgegebenen maximalen Größe der Sonde (112) umfasst, und wobei die Anregung wenigstens einen Anregungspuls umfasst; und
   eine Steuereinrichtung (106) zum Steuern der Anregung, wobei:

   die Sonde so angeordnet ist, dass für jeden Anregungspuls der Anregung Resonanzantwortsignale, die an Entfernungen innerhalb des ausgewählten Bereichs angeregt werden, an der Sonde empfangen werden; und
   das Gerät des Weiteren eine Einrichtung aufweist zum Ermitteln und Verarbeiten von Resonanzantwortsignalen, die an Entfernungen innerhalb des ausgewählten Bereichs an der Sonde empfangen werden; **dadurch gekennzeichnet, dass**
   das Gerät zum Ermitteln des Vorliegens einer verdeckten oder verborgenen Probe dient, wenn sich die verdeckte oder verborgene Probe innerhalb des ausgewählten Entfernungsbereichs von der Sonde (112) befindet;
   die Steuereinrichtung (106) so ausgelegt ist, dass sie die Anregung so steuert, dass jeder Anregungspuls der Anregung eine ausgewählte Breite und Effektivwert-Leistung aufweist, wobei die ausgewählte Breite und Effektivwert-Leistung so ausgewählt werden, dass sichergestellt ist, dass jeder Anregungspuls der Anregung entsprechende Nicht-Null Resonanzantwortsignale an allen Entfernungen innerhalb des ausgewählten Bereichs anregt, unter der Annahme, dass sich die Probe an all diesen Entfernungen befindet;
   die Ermittlungseinrichtung (106) so ausgelegt ist, dass sie die Resonanzantwortsignale verarbeitet, die an Entfernungen innerhalb des ausgewählten Bereichs durch Anlegen des Anregungspulses oder der Anregungspulse der ausgewählten Breite und Effektivwert-Leistung angeregt werden, unabhängig von Resonanzantwortsignalen, die an Entfernungen innerhalb des ausgewählten Bereichs durch Anlegen anderer Anregungspulse angeregt werden, um **dadurch** das Vorliegen der Probe innerhalb des ausgewählten Entfernungsbereichs zu ermitteln.

2. Gerät nach Anspruch 1, wobei die Anregung so ist, dass für eine vorgegebene Probe über den ausgewählten Bereich der Probenentfernung ein minimales Resonanzantwortsignal von nicht weniger als einem Zwanzigstel, vorzugsweise nicht weniger als 1/10, 1/5, 1/4, 1/3 oder 1/2 des maximalen Resonanzantwortsignals erzeugt wird.

3. Gerät nach Anspruch 1 oder 2, wobei die Anregung so ist, dass ein kleinster Pulswinkel (Flip Angle) erzeugt wird, der größer ist als 50%, 75% oder 90% des größten Pulswinkels (Flip Angle) über den ausgewählten Bereich.

4. Gerät nach einem der vorhergehenden Ansprüche, wobei die Anregung eine gepulste Anregung ist, die bei einer Pulswiederholungszeit $\tau$ wiederholt wird, die Probe eine Spin-Gitter-Relaxationszeit $T_1$ hat, und der Wert von $\tau/T_1$ kleiner ist als 5, vorzugsweise kleiner als 2, 1, 0,5, 0,1 oder sogar 0,05.

5. Gerät nach einem der vorhergehenden Ansprüche, wobei die Anregung so ist, dass ein Pulswinkel (Flip Angle) erzeugt wird mit einem Wert, der wenigstens der Wert des Pulswinkels (Flip Angle) ist, der das maximale Resonanzantwortsignal an wenigstens einer Stelle, vorzugsweise an wenigstens zwei getrennten Stellen, in dem ausgewählten Bereich ergibt.

6. Gerät nach einem der vorhergehenden Ansprüche, wobei die Sonde (112) oder wenigstens eine der Sonden (112) in Form einer gewundenen Spule (114) vorliegt.

7. Gerät nach einem der vorhergehenden Ansprüche, wobei die Anregung so ist, dass ein Pulswinkel (Flip Angle) erzeugt wird mit einem Wert, der größer ist, als der Wert des Pulswinkels (Flip Angle), der das maximale Resonanzantwortsignal ergibt, jedoch mit einem Wert, der kleiner ist, als der kleinste Wert eines Pulswinkels (Flip Angle) von größer als 0°, der ein Null-Resonanzantwortsignal ergibt, an dem äußersten Rand des ausgewählten Proben-Entfernungsbereichs, der der oder der einen derartigen Sonde (112) näher liegt.

8. Gerät nach Anspruch 7, wobei die Anregung so ist, dass der äußerste Rand des ausgewählten Proben-Entfernungsbereichs, der der oder der einen derartigen Sonde (112) näher liegt, näher an der Stelle liegt, für die der Pulswinkel (Flip Angle) der kleinste Wert des Pulswinkels (Flip Angle) größer als 0° ist, der ein Null-Resonanzantwortsignal ergibt, als an der Stelle, für die der Pulswinkel (Flip Angle) so ist, dass er ein maximales Resonanzantwortsignal ergibt.

9. Gerät nach Anspruch 7 oder 8, wobei die Anregung so ist, dass der äußerste Rand des ausgewählten Proben-Entfernungsbereichs, das weiter von der oder der einen derartigen Sonde (112) entfernt ist, weiter als die Stelle entfernt ist, für die, für einen Pulswinkel (Flip Angle) mit einem Wert zwischen 0° und dem kleinsten Wert des Pulswinkels (Flip Angle) größer als 0°, der ein Null-Resonanzantwortsignal ergibt, die Anregung so ist, dass das intensivste Resonanzantwortsignal in der Probe erzeugt wird.

10. Gerät nach einem der Ansprüche 7 bis 9, wobei die Anregung so ist, dass der Pulswinkel (Flip Angle) an dem äußersten Rand der ausgewählten Probenentfernung, der weiter von der oder der einen derartigen Sonde (112) entfernt ist, kleiner ist, als der Wert des Pulswinkels (Flip Angle), der das maximale Resonanzantwortsignal ergibt.

11. Gerät nach einem der vorhergehenden Ansprüche, wobei die Anregung eine erste Art von Anregung umfasst und die Einrichtung (110) zum Anlegen der Anregung so ausgelegt ist, dass sie auch eine zweite Art von Anregung, vorzugsweise mit derselben Anregungsfrequenz, anlegen kann, wobei die erste Art von Anregung so ist, dass sie einen Pulswinkel (Flip Angle) erzeugt, der sich an jeder Stelle innerhalb des ausgewählten Bereichs von demjenigen unterscheidet, der von der zweiten Art von Anregung an dieser bestimmten Stelle erzeugt wird, und wobei die Ermittlungseinrichtung (106) so ausgelegt ist, dass sie die Antwortsignale von jeder der ersten und zweiten Art von Anregung ermittelt.

12. Gerät nach einem der Ansprüche 1 bis 10, wobei die Anregung eine erste Art von Anregung umfasst und die Einrichtung (110) zum Anlegen der Anregung so ausgelegt ist, dass sie auch eine zweite Art von Anregung anlegen kann, die einen Puls oder Pulse aufweist, die eine andere Breite und/oder Effektivwert-Leistung haben, als die der ersten Art von Anregung, wobei die zweite Art von Anregung vorzugsweise dieselbe Anregungsfrequenz aufweist wie die erste Art von Anregung.

13. Gerät nach Anspruch 12, wobei die Ermittlungseinrichtung so ausgelegt ist, dass sie die Resonanzantwortsignale von der ersten Art von Anregung unabhängig von den Resonanzantwortsignalen von der zweiten Art von Anregung verarbeitet, und dass sie die Resonanzantwortsignale von der ersten Art von Anregung und/oder die Resonanzantwortsignale von der zweiten Art von Anregung abgleicht, um dieselbe Phase nach Fourier-Transformation zu erzeugen.

14. Gerät nach Anspruch 13, wobei die Ermittlungseinrichtung so ausgelegt ist, dass sie die sich aus der Fourier-Transformation der Resonanzantwortsignale von der ersten Art von Anregung und der Fourier-Transformation der Resonanzantwortsignale von der zweiten Art von Anregung ergebenden Absorptionsspektren hinzufügt, und wobei die Ermittlungseinrichtung vorzugsweise so ausgelegt ist, dass sie den Bereich unter jedem Absorptionsspektrum hinzufügt.

15. Gerät nach einem der Ansprüche 11 bis 14 zum Bestimmen des Grads der Entfernung der Probe von der oder der einen derartigen Sonde (112), die eine Einrichtung (100) aufweist zum Vergleichen der im Ansprechen auf die entsprechenden Arten von Anregung erzeugten Resonanzsignale und zum Bestimmen des Grads der Entfernung der Probe von der oder der einen derartigen Sonde (112) aus dem Vergleich.

16. Gerät nach einem der Ansprüche 11 bis 15, wobei die Einrichtung (110) zum Anlegen von Anregung derart ist, dass sie eine Vielzahl von miteinander überlappenden Arten von Anregung anlegt, um einen sich wiederholenden Anregungszyklus zu bilden, wobei jede der Arten von Anregung während jedes derartigen sich wiederholenden Zyklus angelegt wird.

17. Gerät nach Anspruch 16, wobei in jedem derartigen sich wiederholenden Zyklus die Anregung, die den kleineren oder den kleinsten Pulswinkel (Flip Angle) erzeugt, der Anregung vorangeht, die den größeren oder größten Pulswinkel (Flip Angle) erzeugt.

**18.** Gerät nach einem der Ansprüche 15 bis 17, wobei die Vergleichs- und Bestimmungseinrichtung (100) so ausgelegt ist, dass sie zusätzlich aus dem Vergleich den Grad der Quantität der vorgegebenen Art quadrupolaren Kerns bestimmt.

**19.** Vorrichtung nach einem der Ansprüche 11 bis 18, wobei die Einrichtung (110) zum Anlegen von Anregung so ausgelegt ist, dass sie wenigstens zwei unterschiedliche Paare erster und zweiter Arten von Anregung anlegt.

**20.** Gerät nach Anspruch 11, wobei die erste Art von Anregung so ist, dass an allen Entfernungen innerhalb des ausgewählten Entfernungsbereichs Nicht-Null Resonanzantwortsignale erzeugt werden, und die zweite Art von Anregung so ist, dass an allen Entfernungen innerhalb eines weiteren ausgewählten Entfernungsbereichs Nicht-Null Resonanzantwortsignale erzeugt werden.

**21.** Gerät nach Anspruch 21, wobei der ausgewählte Entfernungsbereich und der weitere ausgewählte Entfernungsbereich benachbart sind oder einander überlappen.

**22.** Gerät nach einem der vorhergehenden Ansprüche, das des Weiteren eine Einrichtung zum Erzeugen eines Alarmsignals in Abhängigkeit davon, ob das Vorliegen einer vorgegebenen Substanz über einer vorgegebenen Schwelle ermittelt wird, aufweist.

**23.** Verfahren zum Ermitteln des Vorliegens einer fernen Probe mit einer vorgegebenen Art quadrupolaren Kerns, das umfasst:

Bereitstellen wenigstens einer Sonde (112) mit einer vorgegebenen maximalen Querschnittsgröße;
Anlegen von Anregung an die Sonde, um nukleare Quadrupolresonanz für einen ausgewählten Entfernungsbereich der Probe von der Sonde (112) anzuregen, wobei über den ausgewählten Bereich ein nicht-uniformes Feld erzeugt wird, wobei der ausgewählte Bereich wenigstens ein Zehntel der vorgegebenen maximalen Größe der Sonde (112) umfasst, und wobei die Anregung wenigstens einen Anregungspuls umfasst;
für jeden Anregungspuls der Anregung Empfangen von Resonanzantwortsignalen, die an Entfernungen innerhalb des ausgewählten Bereichs angeregt werden, an der Sonde; und
Ermitteln und Verarbeiten von Resonanzantwortsignalen, die an Entfernungen innerhalb des ausgewählten Bereichs an der Sonde (112) empfangen werden;
**dadurch gekennzeichnet, dass**
das Verfahren zum Ermitteln des Vorliegens einer verdeckten oder verborgenen Probe dient, wenn sich die verdeckte oder verborgene Probe innerhalb des ausgewählten Entfernungsbereichs von der Sonde (112) befindet;
das Verfahren des Weiteren das Steuern der Anregung so umfasst, dass jeder Anregungspuls der Anregung eine ausgewählte Breite und Effektivwert-Leistung aufweist, wobei die ausgewählte Breite und Effektivwert-Leistung so ausgewählt werden, dass sichergestellt ist, dass jeder Anregungspuls der Anregung entsprechende Nicht-Null Resonanzantwortsignale an allen Entfernungen innerhalb des ausgewählten Bereichs anregt, unter der Annahme, dass sich die Probe an all diesen Entfernungen befindet;
die Resonanzantwortsignale, die an Entfernungen innerhalb des ausgewählten Bereichs durch Anlegen der Anregungspulse der ausgewählten Breite und Effektivwert-Leistung angeregt werden, unabhängig von Resonanzantwortsignalen, die an Entfernungen innerhalb des ausgewählten Bereichs durch Anlegen anderer Anregungspulse angeregt werden, verarbeitet werden, um **dadurch** das Vorliegen der Probe innerhalb des ausgewählten Entfernungsbereichs zu ermitteln.

**24.** Verfahren nach Anspruch 23, wobei die Anregung so ist, dass für eine vorgegebene Probe über den ausgewählten Bereich der Probenentfernung das minimale Resonanzantwortsignal, das ermittelt wird, nicht weniger als ein Zwanzigstel, vorzugsweise nicht weniger als 1/10, 1/5, ¼, 1/3 oder ½ des maximalen Resonanzantwortsignals beträgt.

**25.** Verfahren nach Anspruch 23 oder 24, wobei die Anregung so ist, dass ein kleinster Pulswinkel (Flip Angle) erzeugt wird, der größer ist als 50%, 75% oder 90% des größten Pulswinkels über den ausgewählten Bereich.

**26.** Verfahren nach einem der Ansprüche 23 bis 25, wobei die Anregung eine gepulste Anregung ist, die bei einer Pulswiederholungszeit $\tau$ wiederholt wird, die Probe eine Spin-Gitter-Relaxationszeit $T_1$ hat, und der Wert von $\tau/T_1$ kleiner ist als 5, vorzugsweise kleiner als 2, 1, 0,5, 0,1 oder sogar 0,05.

**27.** Verfahren nach einem der Ansprüche 23 bis 26, wobei die Anregung so ist, dass ein Pulswinkel (Flip Angle) erzeugt wird mit einem Wert, der wenigstens der Wert des Pulswinkels (Flip Angle) ist, der das maximale Resonanzantwortsignal an wenigstens einer Stelle, vorzugsweise an wenigstens zwei getrennten Stellen, in dem ausgewählten Bereich ergibt.

28. Verfahren nach einem der Ansprüche 23 bis 27, wobei die Anregung so ist, dass ein Pulswinkel (Flip Angle) erzeugt wird mit einem Wert, der größer ist, als der Wert des Pulswinkels (Flip Angle), der das maximale Resonanzantwortsignal ergibt, jedoch mit einem Wert, der kleiner ist, als der kleinste Wert eines Pulswinkels (Flip Angle) von größer als 0°, der ein Null-Resonanzantwortsignal ergibt, an dem äußersten Rand des ausgewählten Proben-Entfernungsbereichs, der der oder der einen derartigen Sonde (112) näher liegt.

29. Verfahren nach Anspruch 28, wobei die Anregung so ist, dass der äußerste Rand des ausgewählten Proben-Entfernungsbereichs, der der oder der einen derartigen Sonde (112) näher liegt, näher an der Stelle liegt, für die der Pulswinkel (Flip Angle) der kleinste Wert des Pulswinkels (Flip Angle) größer als 0° ist, der ein Null-Resonanzantwortsignal ergibt, als an der Stelle, für die der Pulswinkel (Flip Angle) so ist, dass er ein maximales Resonanzantwortsignal ergibt.

30. Verfahren nach Anspruch 28 oder 29, wobei die Anregung so ist, dass der äußerste Rand des ausgewählten Proben-Entfernungsbereichs, der weiter von der oder der einen derartigen Sonde (112) entfernt ist, weiter als die Stelle entfernt ist, für die, für einen Pulswinkel (Flip Angle) mit einem Wert zwischen 0° und dem kleinsten Wert des Pulswinkels (Flip Angle) größer als 0°, der ein Null-Resonanzantwortsignal ergibt, die Anregung so ist, dass das intensivste Resonanzantwortsignal in der Probe erzeugt wird.

31. Verfahren nach einem der Ansprüche 28 bis 30, wobei die Anregung so ist, dass der Pulswinkel (Flip Angle) an dem äußersten Rand der ausgewählten Probenentfernung, der weiter von der oder der einen derartigen Sonde (112) entfernt ist, kleiner ist, als der Wert des Pulswinkels (Flip Angle), der das maximale Resonanzantwortsignal ergibt.

32. Verfahren nach einem der Ansprüche 23 bis 31, wobei die Anregung eine erste Art von Anregung umfasst und das Verfahren des Weiteren das Anlegen einer zweiten Art von Anregung, vorzugsweise mit derselben Anregungsfrequenz, umfasst, wobei die erste Art von Anregung so ist, dass sie einen Pulswinkel (Flip Angle) erzeugt, der sich an jeder Stelle innerhalb des ausgewählten Bereichs von demjenigen unterscheidet, der von der zweiten Art von Anregung an dieser bestimmten Stelle erzeugt wird.

33. Verfahren nach einem der Ansprüche 23 bis 32, wobei die Anregung eine erste Art von Anregung umfasst und das Verfahren des Weiteren das Anlegen einer zweiten Art von Anregung umfasst, die einen Puls oder Pulse aufweist, die eine andere Breite und/oder Effektivwert-Leistung haben, als die der ersten Art von Anregung, wobei die zweite Art von Anregung vorzugsweise dieselbe Anregungsfrequenz aufweist wie die erste Art von Anregung.

34. Verfahren nach Anspruch 33, das des Weiteren das Verarbeiten der Resonanzantwortsignale von der ersten Art von Anregung unabhängig von den Resonanzantwortsignalen von der zweiten Art von Anregung umfasst, und das Abgleichen der Resonanzantwortsignale von der ersten Art von Anregung und/oder der Resonanzantwortsignale von der zweiten Art von Anregung, um dieselbe Phase nach Pourier-Transformation zu erzeugen.

35. Verfahren nach Anspruch 34, das des Weiteren das Hinzufügen der sich aus der Fourier-Transformation der Resonanzantwortsignale von der ersten Art von Anregung und der Fourier-Transformation der Resonanzantwortsignale von der zweiten Art von Anregung ergebenden Absorptionsspektren umfasst, und vorzugsweise umfasst das Verfahren das Hinzufügen des Bereichs unter jedem Absorptionsspektrum.

36. Verfahren nach einem der Ansprüche 32 bis 35, wobei die Vielzahl von Arten von Anregung miteinander überlappt werden, um einen sich wiederholenden Anregungszyklus zu bilden, wobei jede der Arten von Anregung während jedes derartigen sich wiederholenden Zyklus angelegt wird.

37. Verfahren nach Anspruch 36, wobei in jedem derartigen sich wiederholenden Zyklus die Anregung, die den kleineren oder den kleinsten Pulswinkel (Flip Angle) erzeugt, der Anregung vorangeht, die den größeren oder größten Pulswinkel (Flip Angle) erzeugt.

38. Verfahren nach einem der Ansprüche 32 bis 37, wobei die im Ansprechen auf die jeweiligen Arten von Anregung erzeugten Resonanzsignale separat erhalten und verarbeitet werden.

**EP 0 838 036 B1**

39. Verfahren nach einem der Ansprüche 32 bis 38 zum Bestimmen des Grads der Entfernung der Probe von der oder der einen derartigen Sonde (112), wobei die im Ansprechen auf die entsprechenden Arten von Anregung erzeugten Resonanzsignale verglichen werden und der Grad der Entfernung der Probe von der oder der einen derartigen Sonde (112) aus dem Vergleich bestimmt wird.

40. Verfahren nach Anspruch 39, wobei zusätzlich aus dem Vergleich der Grad der Quantität der vorgegebenen Art quadrupolaren Kerns bestimmt wird.

41. Verfahren nach einem der Ansprüche 32 bis 40, wobei wenigstens zwei unterschiedliche Paare erster und zweiter Arten von Anregung angelegt werden.

42. Verfahren nach Anspruch 41, wobei die erste Art von Anregung so ist, dass an allen Entfernungen innerhalb des ausgewählten Bereichs Nicht-Null Resonanzantwortsignale erzeugt werden, und die zweite Art von Anregung so ist, dass an allen Entfernungen innerhalb eines weiteren ausgewählten Entfernungsbereichs Nicht-Null Resonanzantwortsignale erzeugt werden.

43. Verfahren nach Anspruch 42, wobei der ausgewählte Entfernungsbereich und der weitere ausgewählte Entfernungsbereich benachbart sind oder einander überlappen.

**Revendications**

1. Appareil destiné à détecter la présence d'un échantillon à distance contenant une espèce donnée de noyau quadripolaire, comprenant :

   au moins une sonde (112) ayant une dimension transversale maximale donnée ;
   un moyen (110) destiné à appliquer une excitation à la sonde (112) pour exciter la résonance quadripolaire nucléaire pour une plage de distance sélectionnée de l'échantillon par rapport à la sonde, l'appareil étant adapté pour produire un champ non uniforme sur la plage sélectionnée, la plage sélectionnée étant au moins d'un dixième de la dimension maximale donnée de la sonde (112) et l'excitation comprenant au moins une impulsion d'excitation ; et
   un moyen de commande (106) destiné à commander l'excitation, dans lequel :

   la sonde est agencée de façon que, pour chaque impulsion d'excitation de l'excitation, des signaux de réponse de résonance excités à des distances dans la plage sélectionnée soient reçus au niveau de la sonde ; et
   l'appareil comprend en outre un moyen destiné à détecter et à traiter les signaux de réponse de résonance excités à des distances dans la plage sélectionnée reçus au niveau de la sonde ;
   **caractérisé en ce que** :

   l'appareil est destiné à détecter la présence d'un échantillon enterré ou dissimulé si l'échantillon enterré ou dissimulé est présent dans la plage de distance sélectionnée par rapport à la sonde (112) ;
   le moyen de commande (106) est adapté pour commander l'excitation de façon que chaque impulsion d'excitation de l'excitation soit d'une largeur et d'une puissance quadratique moyenne sélectionnées, la largeur et la puissance quadratique moyenne sélectionnées étant sélectionnées pour être telles qu'elles garantissent que chaque impulsion d'excitation de l'excitation excite des signaux de réponse de résonance non nuls respectifs à toutes les distances dans la plage sélectionnée, en supposant que l'échantillon était présent à toutes ces distances ;
   le moyen de détection (106) est adapté pour traiter les signaux de réponse de résonance, excités à des distances dans la plage sélectionnée par l'application de l'impulsion ou des impulsions d'excitation de la largeur et de la puissance quadratique moyenne sélectionnées, indépendamment de tout signal de réponse de résonance excité à des distances dans la plage sélectionnée par l'application de toute autre impulsion d'excitation, pour détecter de ce fait la présence de l'échantillon dans la plage de distance sélectionnée.

2. Appareil selon la revendication 1, dans lequel l'excitation est telle qu'elle génère, pour un échantillon donné, sur la plage de distance d'échantillon sélectionnée un signal de réponse de résonance minimal d'au moins un vingtième, de préférence d'au moins 1/10, 1/5, 1/4, 1/3 ou ½, du signal de réponse de résonance maximal.

22

3. Appareil selon la revendication 1 ou 2, dans lequel l'excitation est telle qu'elle génère un angle de bascule le plus faible qui est supérieur à 50 %, 75 %, ou 90 % de l'angle de bascule le plus élevé sur la plage sélectionnée.

4. Appareil selon l'une quelconque des revendications précédentes, dans lequel l'excitation est une excitation pulsée répétée à un temps de répétition d'impulsion $\tau$, l'échantillon a un temps de relaxation spin-réseau $T_1$, et la valeur de $\tau/T_1$ est inférieure à 5, de préférence inférieure à 2, 1, 0,5, 0,1 ou même à 0,05.

5. Appareil selon l'une quelconque des revendications précédentes, dans lequel l'excitation est telle qu'elle génère un angle de bascule ayant une valeur qui est au moins la valeur de l'angle de bascule qui donne le signal de réponse de résonance maximal, à au moins un emplacement, de préférence à au moins deux emplacements séparés, dans la plage sélectionnée.

6. Appareil selon l'une quelconque des revendications précédentes, dans lequel la sonde (112) ou au moins une des sondes (112) se trouve sous la forme d'une bobine en spirale (114).

7. Appareil selon l'une quelconque des revendications précédentes, dans lequel l'excitation est telle qu'elle génère un angle de bascule d'une valeur supérieure à la valeur de l'angle de bascule qui donne le signal de réponse de résonance maximal, mais d'une valeur inférieure à la valeur la plus faible de l'angle de bascule supérieur à 0° qui donne un signal de réponse de résonance nul, au niveau de cet extrême de la plage de distance d'échantillon sélectionnée plus proche de la ou de ladite une telle sonde (112).

8. Appareil selon la revendication 7, dans lequel l'excitation est telle que cet extrême de la plage de distance d'échantillon sélectionnée plus proche de la ou de ladite une telle sonde (112) est plus proche de l'emplacement pour lequel l'angle de bascule est la valeur la plus faible de l'angle de bascule supérieur à 0° qui donne un signal de réponse de résonance nul que de l'emplacement pour lequel l'angle de bascule est tel qu'il donne un signal de réponse de résonance maximal.

9. Appareil selon la revendication 7 ou 8, dans lequel l'excitation est telle que cet extrême de la plage de distance d'échantillon sélectionnée plus éloignée de la ou de ladite une telle sonde (112) est plus éloigné que l'emplacement pour lequel, pour un angle de bascule ayant une valeur entre 0° et la valeur la plus faible de l'angle de bascule supérieur à 0° qui donne un signal de réponse de résonance nul, l'excitation est telle qu'elle génère le signal de réponse de résonance le plus intense dans l'échantillon.

10. Appareil selon l'une quelconque des revendications 7 ou 9, dans lequel l'excitation est telle que l'angle de bascule au niveau de cet extrême de la distance d'échantillon sélectionnée plus éloigné de la ou de ladite une telle sonde (112) est inférieur à la valeur de l'angle de bascule qui donne le signal de réponse de résonance maximal.

11. Appareil selon l'une quelconque des revendications précédentes, dans lequel l'excitation comprend un premier type d'excitation et le moyen d'application d'excitation (110) est également adapté pour appliquer un second type d'excitation, de préférence à la même fréquence d'excitation, le premier type d'excitation étant agencé pour générer un angle de bascule qui diffère à chaque emplacement sans exception dans la plage sélectionnée de celui généré par le second type d'excitation à cet emplacement particulier, et le moyen de détection (106) est adapté pour détecter les signaux de réponse à partir de chacun des premier et second types d'excitation.

12. Appareil selon l'une quelconque des revendications 1 à 10, dans lequel l'excitation comprend un premier type d'excitation, et le moyen d'application d'excitation (110) est également adapté pour appliquer un second type d'excitation comprenant une impulsion ou des impulsions ayant une largeur et/ou une puissance quadratique moyenne différant de celle(s) du premier type d'excitation, le second type d'excitation étant de préférence à la même fréquence d'excitation que celle du premier type d'excitation.

13. Appareil selon la revendication 12, dans lequel le moyen de détection est adapté pour traiter les signaux de réponse de résonance à partir du premier type d'excitation indépendamment des signaux de réponse de résonance à partir du second type d'excitation, et pour ajuster les signaux de réponse de résonance à partir du premier type d'excitation et/ou les signaux de réponse de résonance à partir du second type d'excitation, de façon à produire la même phase après une transformation de Fourier.

14. Appareil selon la revendication 13, dans lequel le moyen de détection est adapté pour ajouter les spectres d'absorption provenant de la transformation de Fourier des signaux de réponse de résonance à partir du premier type d'excitation et de la transformation de Fourier des signaux de réponse de résonance à partir du second type d'excitation, et de préférence le moyen de détection est adapté pour ajouter la surface sous chaque spectre d'absorption.

**15.** Appareil selon l'une quelconque des revendications 11 à 14, destiné à déterminer une mesure de la distance de l'échantillon par rapport à la ou à ladite une telle sonde (112), comprenant un moyen (100) destiné à comparer les signaux de résonance générés en réponse aux types d'excitation respectifs et à déterminer à partir de la comparaison une mesure de la distance de l'échantillon par rapport à la ou à ladite une telle sonde (112).

**16.** Appareil selon l'une quelconque des revendications 11 à 15, dans lequel le moyen d'application d'excitation (110) est tel qu'il applique la pluralité de types d'excitation imbriqués les uns dans les autres pour former un cycle de répétition d'excitation, chacun des types d'excitation étant appliqué au cours de chacun des tels cycles de répétition.

**17.** Appareil selon la revendication 16, dans lequel, dans chacun des tels cycles de répétition, l'excitation générant l'angle de bascule plus faible ou le plus faible précède l'excitation générant l'angle de bascule plus élevé ou le plus élevé.

**18.** Appareil selon l'une quelconque des revendications 15 à 17, dans lequel le moyen de comparaison et de détermination (100) est en outre adapté pour déterminer à partir de la comparaison une mesure de la quantité de l'espèce donnée de noyau quadripolaire.

**19.** Appareil selon l'une quelconque des revendications 11 à 18, dans lequel le moyen d'application d'excitation (110) est adapté pour appliquer au moins deux paires différentes des premier et second types d'excitation.

**20.** Appareil selon la revendication 11, dans lequel le premier type d'excitation est tel qu'il génère des signaux de réponse de résonance non nuls à toutes les distances dans la plage de distance sélectionnée, et le second type d'excitation est tel qu'il génère des signaux de réponse de résonance non nuls à toutes les distances dans une plage de distance sélectionnée supplémentaire.

**21.** Appareil selon la revendication 21, dans lequel la plage de distance sélectionnée et la plage de distance sélectionnée supplémentaire sont contiguës ou se chevauchent.

**22.** Appareil selon l'une quelconque des revendications précédentes, comprenant en outre un moyen destiné à générer un signal d'alarme en fonction du fait que la présence d'une substance donnée est détectée au-dessus d'un seuil prédéterminé ou non.

**23.** Procédé de détection de la présence d'un échantillon à distance contenant une espèce donnée d'un noyau quadripolaire, comprenant :

la fourniture d'au moins une sonde (112) ayant une dimension transversale maximale donnée ;
l'application d'une excitation à la sonde pour exciter la résonance quadripolaire nucléaire pour une plage de distance sélectionnée de l'échantillon par rapport à la sonde (112), un champ non uniforme étant produit sur la plage sélectionnée, la plage sélectionnée étant au moins d'un dixième de la dimension maximale donnée de la sonde (112), et l'excitation comprenant au moins une impulsion d'excitation ;
pour chaque impulsion d'excitation de l'excitation, la réception au niveau de la sonde des signaux de réponse de résonance excités à des distances dans la plage sélectionnée ; et
la détection et le traitement des signaux de réponse de résonance excités à des distances dans la plage sélectionnée reçus au niveau de la sonde (112) ;
**caractérisé en ce que** :

le procédé est destiné à détecter la présence d'un échantillon enterré ou dissimulé si l'échantillon enterré ou dissimulé est présent dans la plage de distance sélectionnée par rapport à la sonde (112) ;
le procédé comprend en outre la commande de l'excitation de façon que chaque impulsion d'excitation de l'excitation soit d'une largeur et d'une puissance quadratique moyenne sélectionnées, la largeur et la puissance quadratique moyenne sélectionnées étant sélectionnées pour être telles qu'elles assurent que chaque impulsion d'excitation de l'excitation excite des signaux de réponse de résonance non nuls respectifs à toutes les distances dans la plage sélectionnée, en supposant que l'échantillon était présent à toutes ces distances ;
le traitement des signaux de réponse de résonance, excités à des distances dans la plage sélectionnée par l'application des impulsions d'excitation de la largeur et de la puissance quadratique moyenne sélectionnées, indépendamment de tout signal de réponse de résonance excité à des distances dans la plage sélectionnée par l'application de toute autre impulsion d'excitation, pour détecter de ce fait la présence de l'échantillon dans la plage de distance sélectionnée.

24. Procédé selon la revendication 23, dans lequel l'excitation est telle que, pour un échantillon donné, sur la plage de distance d'échantillon sélectionnée, le signal de réponse de résonance minimal détecté est d'au moins un vingtième, de préférence d'au moins 1/10, 1/5, 1/4, 1/3 ou ½ du signal de réponse de résonance maximal.

25. Procédé selon la revendication 23 ou 24, dans lequel l'excitation est telle qu'elle génère un angle de bascule le plus faible qui est supérieur à 50 %, 75 %, ou 90 % de l'angle de bascule le plus élevé sur la plage sélectionnée.

26. Procédé selon l'une quelconque des revendications 23 à 25, dans lequel l'excitation est une excitation pulsée répétée à un temps de répétition d'impulsion $\tau$, l'échantillon a un temps de relaxation spin-réseau $T_1$, et la valeur de $\tau/T_1$ est inférieure à 5, de préférence inférieure à 2, 1, 0,5, 0,1 ou même à 0,05.

27. Procédé selon l'une quelconque des revendications 23 à 26, dans lequel l'excitation est telle qu'elle génère un angle de bascule ayant une valeur qui est au moins la valeur de l'angle de bascule qui donne le signal de réponse de résonance maximal, à au moins un emplacement, de préférence à au moins deux emplacements séparés, dans la plage sélectionnée.

28. Procédé selon l'une quelconque des revendications 23 à 27, dans lequel l'excitation est telle qu'elle génère un angle de bascule d'une valeur supérieure à la valeur de l'angle de bascule qui donne le signal de réponse de résonance maximal, mais d'une valeur inférieure à la valeur la plus faible de l'angle de bascule supérieur à 0° qui donne un signal de réponse de résonance nul, au niveau de cet extrême de la plage de distance d'échantillon sélectionnée le plus proche de la ou de ladite une telle sonde (112).

29. Procédé selon la revendication 28, dans lequel l'excitation est telle que cet extrême de la plage de distance d'échantillon sélectionnée le plus proche de la ou de ladite une telle sonde (112) est plus proche de l'emplacement pour lequel l'angle de bascule est la valeur la plus faible de l'angle de bascule supérieur à 0° qui donne un signal de réponse de résonance nul que de l'emplacement pour lequel l'angle de bascule est tel qu'il donne un signal de réponse de résonance maximal.

30. Procédé selon la revendication 28 ou 29, dans lequel l'excitation est telle que cet extrême de la plage de distance d'échantillon sélectionnée le plus éloigné de la ou de ladite une telle sonde (112) est plus éloigné que l'emplacement pour lequel, pour un angle de bascule ayant une valeur entre 0° et la valeur la plus faible de l'angle de bascule supérieur à 0° qui donne un signal de réponse de résonance nul, l'excitation est telle qu'elle génère le signal de réponse de résonance le plus intense dans l'échantillon.

31. Procédé selon l'une quelconque des revendications 28 à 30, dans lequel l'excitation est telle que l'angle de bascule au niveau de cet extrême de la distance d'échantillon sélectionnée le plus éloigné de la ou de ladite une telle sonde (112) est inférieur à la valeur de l'angle de bascule qui donne le signal de réponse de résonance maximal.

32. Procédé selon l'une quelconque des revendications 23 à 31, dans lequel l'excitation comprend un premier type d'excitation, et le procédé comprend en outre l'application d'un second type d'excitation, de préférence à la même fréquence d'excitation, le premier type d'excitation étant agencé pour générer un angle de bascule qui diffère à chaque emplacement sans exception dans la plage sélectionnée de celui généré par le second type d'excitation à cet emplacement particulier.

33. Procédé selon l'une quelconque des revendications 23 à 32, dans lequel l'excitation comprend un premier type d'excitation, et le procédé comprend en outre l'application d'un second type d'excitation comprenant une impulsion ou des impulsions ayant une largeur et/ou une puissance quadratique moyenne différant de celle(s) du premier type d'excitation, le second type d'excitation étant de préférence à la même fréquence d'excitation que celle du premier type d'excitation.

34. Procédé selon la revendication 33, comprenant en outre le traitement des signaux de réponse de résonance à partir du premier type d'excitation indépendamment des signaux de réponse de résonance à partir du second type d'excitation, et l'ajustement des signaux de réponse de résonance à partir du premier type d'excitation et/ou des signaux de réponse de résonance à partir du second type d'excitation, de façon à produire la même phase après une transformation de Fourier.

35. Procédé selon la revendication 34, comprenant en outre l'ajout des spectres d'absorption provenant de la transformation de Fourier des signaux de réponse de résonance à partir du premier type d'excitation et de la transformation de Fourier des signaux de réponse de résonance à partir du second type d'excitation, et de préférence le procédé comprend l'ajout de la surface sous chaque spectre d'absorption.

36. Procédé selon l'une quelconque des revendications 32 à 35, dans lequel la pluralité de types d'excitation sont imbriqués les uns dans les autres pour former un cycle de répétition d'excitation, chacun des types d'excitation étant appliqué au cours de chacun des tels cycles de répétition.

37. Procédé selon la revendication 36, dans lequel, dans chacun des tels cycles de répétition, l'excitation générant l'angle de bascule plus faible ou le plus faible précède l'excitation générant l'angle de bascule plus élevé ou le plus élevé.

38. Procédé selon l'une quelconque des revendications 32 à 37, dans lequel les signaux de résonance générés en réponse aux types d'excitation respectifs sont acquis et traités séparément.

39. Procédé selon l'une quelconque des revendications 32 à 38, de détermination d'une mesure de la distance de l'échantillon par rapport à la ou à ladite une telle sonde (112), dans lequel les signaux de résonance générés en réponse aux types d'excitation respectifs sont comparés et une mesure de la distance de l'échantillon par rapport à la ou à ladite une telle sonde (112) est déterminée à partir de la comparaison.

40. Procédé selon la revendication 39, dans lequel est en outre déterminée à partir de la comparaison une mesure de la quantité de l'espèce donnée de noyau quadripolaire.

41. Procédé selon l'une quelconque des revendications 32 à 40, dans lequel au moins deux paires différentes des premier et second types d'excitation sont appliquées.

42. Procédé selon la revendication 41, dans lequel le premier type d'excitation est tel qu'il génère des signaux de réponse de résonance non nuls à toutes les distances dans la plage sélectionnée, et le second type d'excitation est tel qu'il génère des signaux de réponse de résonance non nuls à toutes les distances dans une plage de distance sélectionnée supplémentaire.

43. Procédé selon la revendication 42, dans lequel la plage de distance sélectionnée et la plage de distance sélectionnée supplémentaire sont contiguës ou se chevauchent.

Fig. 1

Fig.2

R.F. Signal From
Pulse Programmer
130

Channel B

R.F. Signal
to Amplifier
110

134

146

Channel A

142

144

0

90

140

136

R.F. Signal in
From Spectrometer
132

*Fig. 3*

*Fig. 4*

EP 0 838 036 B1

Fig. 5

EP 0 838 036 B1

Fig. 6(a)  FREQUENCY

Fig. 6(b)  FREQUENCY

Fig. 7  FREQUENCY

*Fig. 8*

EP 0 838 036 B1

Fig. 9

*Fig. 10*

*Fig. 11*

EP 0 838 036 B1

*Fig. 12*